# EUROPEAN PATENT APPLICATION

(11) **EP 2 985 325 A1**
(43) Date of publication of application: **17.02.2016**
(21) Application number: 14782541.8
(22) Date of filing: 10.04.2014
(51) Int. Cl.: C09D 201/00, C09D 5/32, C09D 7/12, G03F 7/004

(54) **COMPOSITION FOR FORMING FAR-INFRARED RADIATION SHIELDING LAYER**

(30) Priority: 12.04.2013 JP 2013083991
(71) Applicant: Fujifilm Corporation, Minato-ku Tokyo 106-8620 (JP)
(72) Inventor: HAMADA Daisuke, Haibara-gun Shizuoka 421-0396 (JP); NARA Yuki, Haibara-gun Shizuoka 421-0396 (JP); KUBOTA Makoto, Haibara-gun Shizuoka 421-0396 (JP); SHIMADA Kazuto, Haibara-gun Shizuoka 421-0396 (JP); ARAYAMA Kyohei, Haibara-gun Shizuoka 421-0396 (JP)
(74) Representative: Hoffmann Eitle
(86) International application number: PCT/JP2014/060434
(87) International publication number: WO 2014/168217

(57) **Abstract**

An object of the present invention is to provide a composition for forming a far-infrared radiation shielding layer which is able to form a layer having excellent far-infrared radiation shielding properties. A composition for forming a far-infrared radiation shielding layer of the present invention contains at least inorganic fine particles and a dispersant.

## Description

### BACKGROUND OF THE INVENTION

The present invention relates to a composition for forming a far-infrared radiation shielding layer.

From the related art, an infrared ray sensor has been used as a temperature sensor which measures the temperature of a measurement target by detecting an infrared ray emitted from the measurement target by radiation in a non-contact state. For example, in a case of an infrared array sensor, pixels are arranged into the shape of an array in a portion for sensing the infrared ray, and a light sensing unit of the pixel has a thin film-like structure.

As an infrared radiation shielding material (an infrared ray absorption material) used in a usage relevant to various infrared rays for an infrared ray sensor or the like, an organic pigment as disclosed in JP2010-090313A has been well known.

### SUMMARY OF THE INVENTION

On the other hand, recently, there has been a demand for the development of a material having excellent light shielding performance for a far-infrared ray according to a demand for performance improvement in the infrared ray sensor.

The present inventors have conducted studies on the light shielding performance of the far-infrared ray by using the organic pigment as disclosed in JP2010-090313A, and as a result thereof, they have found that the performance does not necessarily reach a level which is currently required, and thus it is necessary that the performance is further improved.

In consideration of the circumstances described above, an object of the present invention is to provide a composition for forming a far-infrared radiation shielding layer which is able to form a layer having excellent far-infrared radiation shielding properties.

As a result of intensive studies, the present inventors have found that the problems described above are able to be solved by the following configurations.
(1) A composition for forming a far-infrared radiation shielding layer contains at least inorganic fine particles and a dispersant.
(2) The composition for forming a far-infrared radiation shielding layer according to (1), in which the inorganic fine particles are conductive inorganic fine particles.
(3) The composition for forming a far-infrared radiation shielding layer according to (1) or (2), in which transmittance (%) of the inorganic fine particles at 365 nm to 405 nm is greater than or equal to 10%.
(4) The composition for forming a far-infrared radiation shielding layer according to any one of (1) to (3), in which the inorganic fine particles are indium tin oxide.
(5) The composition for forming a far-infrared radiation shielding layer according to any one of (1) to (4), in which the dispersant contains a resin which has a repeating unit having a group X having a functional group of which pKa is less than or equal to 14, and an oligomer chain or a polymer chain Y having 40 to 10,000 atoms on a side chain, and contains a basic nitrogen atom, or a polymer compound which has a weight average molecular weight of less than or equal to 10,000 and is denoted by General Formula (1) described below.
(6) The composition for forming a far-infrared radiation shielding layer according to any one of (1) to (5), further containing a polymerization initiator, a polymerizing monomer, and a binder polymer.
(7) The composition for forming a far-infrared radiation shielding layer according to any one of (4) to (6), in which a content of the indium tin oxide is greater than or equal to 50 mass% in a total solid content.

According to the present invention, it is possible to provide a composition for forming a far-infrared radiation shielding layer which is able to form a layer having excellent far-infrared radiation shielding properties.

### DETAILED DESCRIPTION OF THE INVENTION

Hereinafter, preferred embodiments of a composition for forming a far-infrared radiation shielding layer according to the present invention will be described.

In the composition for forming a far-infrared radiation shielding layer (hereinafter, simply referred to as a "composition"), at least inorganic fine particles and a dispersant are contained.

Furthermore, herein, the far-infrared ray indicates light having a wavelength of greater than 3 µm and less than or equal to 25 µm.

Hereinafter, first, each component contained in the composition will be described in detail.

### <Inorganic Fine Particles>

The inorganic fine particles are particles mainly having a function of shielding (absorbing) a far-infrared ray.

As the inorganic fine particles, it is preferable to use inorganic fine particles (conductive inorganic fine particles) having conductivity from a viewpoint of more excellent far-infrared radiation shielding properties.

In addition, as described below, when a polymerizing monomer is contained in the composition for forming a far-infrared radiation shielding layer, it is preferable that the transmittance (%) of the inorganic fine particles at 365 nm to 405 nm is greater than or equal to 10% from a viewpoint of more excellent pattern resolution. Furthermore, setting the transmittance (%) of the inorganic fine particles at 365 nm to 405 nm to be greater than or equal to 10% indicates that when the transmittance of a far-infrared radiation shielding layer (a cured film) which is formed by using the composition for forming a far-infrared radiation shielding layer at a wavelength of 10 µm is 10%, the transmittance of the composition for forming a far-infrared radiation shielding layer at 365 nm to 405 nm is greater than or equal to 10%.

As the inorganic fine particles, for example, inorganic fine particles formed of one or a plurality of materials selected from a group consisting of indium tin oxide (ITO) (tin-doped indium oxide, and for example, as a marketed product, P4-ITO (manufactured by Mitsubishi Materials Corporation)), antimony trioxide (ATO), zinc oxide which may be doped with aluminum (ZnO which may be doped with Al), fluorine-doped tin dioxide (F-doped SnO₂), niobium doped titanium dioxide (Nb-doped TiO₂), silver (Ag), gold (Au), copper (Cu), and nickel (Ni) are able to be included. Furthermore, in order to make far-infrared light shielding properties and photolithographic properties compatible, it is preferable that transmittance at an exposure wavelength (365 nm to 405 nm) is high. Accordingly, indium tin oxide (ITO) is preferable from a viewpoint of more excellent photolithographic properties.

The shape of the inorganic fine particles is not particularly limited, and the inorganic fine particles may have a sheet-like shape, a wire-like shape, and a tube-like shape in addition to a spherical shape and non-spherical shape.

Only one type of the inorganic fine particles may be used, or two or more types thereof may be used.

The average particle diameter of the inorganic fine particles is not particularly limited, and the average particle diameter is preferably 1 nm to 200 nm, and is more preferably 10 nm to 100 nm from a viewpoint of more excellent far-infrared radiation shielding properties.

Furthermore, the average particle diameter is obtained by measuring the particle diameter (the diameter) of at least 300 inorganic fine particles using a microscope such as an electron microscope, and by arithmetically averaging the measured particle diameters. Furthermore, when the inorganic fine particles are in the shape of an ellipse, the major diameter is measured as the diameter.

In addition, when the inorganic fine particles are sheet-like particles, it is preferable that the average thickness of the sheet-like particles is in the numerical range of the average particle diameter described above, and when the inorganic fine particles are wire-like particles or tube-like particles, it is preferable that the average diameter of the wire-like particles or the tube-like particles is in the numerical range of the average particle diameter described above. Furthermore, when the average thickness or the average diameter described above is obtained, the thicknesses or the diameters of at least 300 non-spherical particles are measured and are arithmetically averaged.

The content of the inorganic fine particles in the composition is not particularly limited, and the content of the inorganic fine particles is preferably greater than or equal to 30 mass%, is more preferably greater than or equal to 40 mass%, and is even more preferably greater than or equal to 50 mass%, with respect to the total solid content of the composition (hereinafter, also referred to as the total solid content of the composition). The upper limit of the content is not particularly limited, and the upper limit of the content is preferably less than or equal to 95 mass%, and is more preferably less than or equal to 80 mass%, with respect to the total solid content of the composition.

Furthermore, the total solid content of the composition described above indicates the total amount of the components configuring the far-infrared radiation shielding layer which are contained in the composition, and a solvent or the like is not included therein.

### <Dispersant>

The dispersant is a compound for ensuring the dispersibility of the inorganic fine particles in the composition.

The type of the dispersant is not particularly limited, and as the dispersant, a suitable compound is selected according to the type of the inorganic fine particles described above. Among them, a resin described below and a polymer compound denoted by General Formula (1) described below are preferably included from a viewpoint that the inorganic fine particles are able to be dispersed in the composition with a high concentration, and a far-infrared radiation shielding layer to be formed is able to be thinned.

Hereinafter, the resin and the polymer compound will be described in detail.

### (Resin (hereinafter, referred to as a dispersion resin))

The dispersion resin has a repeating unit having a group X having a functional group of which pKa is less than or equal to 14, and an oligomer chain or a polymer chain Y having 40 to 10,000 atoms on a side chain, and contains a basic nitrogen atom.

As described below in detail, the oligomer chain or the polymer chain Y functions as a steric repulsion group in order to interact with the inorganic fine particles in both of the nitrogen atom in the dispersion resin and the functional group of which pKa is less than or equal to 14 included in the group X, and to allow the dispersion resin to have the oligomer chain or the polymer chain Y having 40 to 10,000 atoms, and thus excellent dispersibility is able to be exhibited, and the inorganic fine particles are able to be homogeneously dispersed. In addition, even when the composition is stored at room temperature or the like for a long period of time, the oligomer chain or the polymer chain Y and the solvent interact with each other, and thus it is possible to prevent the inorganic fine particles from being precipitated for a long period of time. Further, the oligomer chain or the polymer chain Y functions as the steric repulsion group, and thus the inorganic fine particles are prevented from being aggregated, and therefore even when the content of the inorganic fine particles increases, as described above, the dispersibility and the dispersion stability are rarely impaired.

Here, the basic nitrogen atom is not particularly limited insofar as the nitrogen atom exhibits basicity, and it is preferable that the dispersion resin has a structure including a nitrogen atom of which pKb is less than or equal to 14, and it is more preferable that the dispersion resin has a structure including a nitrogen atom of which pKb is less than or equal to 10.

In the present invention, the base strength pKb indicates pKb at a water temperature of 25°C, is one of indexes quantitatively indicating the strength of a base, and is synonymous with a basicity constant. The base strength pKb and the acid strength pKa have a relationship of pKb = 14 - pKa.

The group X having the functional group of which pKa is less than or equal to 14 is synonymous with the group X described below with respect to a dispersion resin 2-1.

The oligomer chain or the polymer chain Y having 40 to 10,000 atoms included on the side chain of the dispersion resin is also synonymous with the oligomer chain or the polymer chain Y having 40 to 10,000 atoms described below with respect to the dispersion resin.

As the dispersion resin, a resin containing a repeating unit having the group X having the functional group of which pKa is less than or equal to 14 denoted by the following formulas, a repeating unit having the basic nitrogen atom denoted by the following formula, and a repeating unit having the oligomer chain or the polymer chain Y having 40 to 10,000 atoms denoted by the following Formula (sequentially corresponding to repeating units from the left of the structure of the following repeating unit), and the like are included.

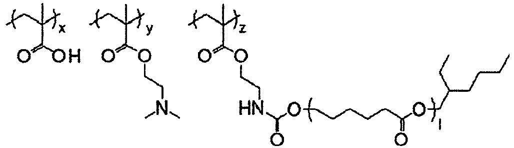

In the formula described above, x, y, and z each represent a polymerization molar ratio of the repeating unit, and it is preferable that x is 5 to 50, y is 5 to 60, and z is 10 to 90. 1 represents the number of connections of a polyester chain, is an integer which is able to form the oligomer chain or the polymer chain having 40 to 10,000 atoms, and is preferably 70 to 2,000.

It is preferable that the dispersion resin has the repeating unit containing a nitrogen atom to which the group X having the functional group of which pKa is less than or equal to 14 is bonded, and the oligomer chain or the polymer chain Y having 40 to 10,000 atoms on the side chain.

It is particularly preferable that the dispersion resin is a dispersion resin (hereinafter, suitably referred to as a "dispersion resin 2-1") having (i) at least one repeating unit containing the nitrogen atom selected from a poly(lower alkylene imine)-based repeating unit, a polyallyl amine-based repeating unit, a polydiallyl amine-based repeating unit, a meta-xylene diamine-epichlorohydrin polycondensation-based repeating unit, and a polyvinyl amine-based repeating unit, which is bonded to the nitrogen atom and has the group X having the functional group of which pKa is less than or equal to 14, and (ii) the oligomer chain or the polymer chain Y having 40 to 10,000 atoms on the side chain.

((i) At Least One Repeating Unit Containing Nitrogen Atom Selected from Poly(Lower Alkylene Imine)-Based Repeating Unit, Polyallyl Amine-Based Repeating Unit, Polydiallyl Amine-Based Repeating Unit, Meta-Xylene Diamine-Epichlorohydrin Polycondensation-Based Repeating Unit, and Polyvinyl Amine-Based Repeating Unit)

The dispersion resin 2-1 has at least one repeating unit (i) containing a nitrogen atom selected from the poly(lower alkylene imine)-based repeating unit, the polyallyl amine-based repeating unit, the polydiallyl amine-based repeating unit, the meta-xylene diamine-epichlorohydrin polycondensation-based repeating unit, and the polyvinyl amine-based repeating unit. Accordingly, it is possible to improve an adsorption force to the surface of the inorganic fine particles, and it is possible to reduce the interaction between the inorganic fine particles.

The poly(lower alkylene imine) may be in the shape of a chain or a net.

The number average molecular weight of a main chain having at least one repeating unit (i) containing a nitrogen atom selected from the poly(lower alkylene imine)-based repeating unit, the polyallyl amine-based repeating unit, the polydiallyl amine-based repeating unit, the meta-xylene diamine-epichlorohydrin polycondensation-based repeating unit, and the polyvinyl amine-based repeating unit, that is, the number average molecular weight of a portion excluding the oligomer chain or the polymer chain Y portion on the side chain from the dispersion resin 2-1 is preferably 100 to 10,000, is more preferably 200 to 5,000, and is most preferably 300 to 2,000. The number average molecular weight of the main chain portion is able to be obtained from a ratio of hydrogen atom integral values of a terminal group and the main chain portion measured by using a nuclear magnetic resonance spectroscopic method, or is able to be obtained by measuring the molecular weight of an oligomer or a polymer containing an amino group which is a raw material.

As the repeating unit (i) containing a nitrogen atom, the poly(lower alkylene imine)-based repeating unit, or the polyallyl amine-based repeating unit is particularly preferable. Furthermore, in the present invention, lower of the poly(lower alkylene imine) indicates that the number of carbon atoms is 1 to 5, and the lower alkylene imine indicates alkylene imine having 1 to 5 carbon atoms. When this structure is specified, it is preferable that the dispersion resin 2-1 has a structure including a repeating unit denoted by General Formula (I-1) described below and a repeating unit denoted by General Formula (1-2) described below, or a structure including a repeating unit denoted by General Formula (II-1) described below and a repeating unit denoted by General Formula (II-2) described below.

### (Repeating Unit Denoted by General Formula (I-1) and Repeating Unit Denoted by General Formula (I-2))

The repeating unit denoted by General Formula (I-1) and the repeating unit denoted by General Formula (I-2) which are preferred constituents of the dispersion resin 2-1 will be described in detail.

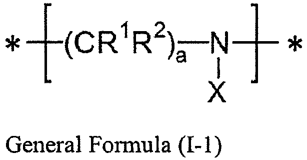

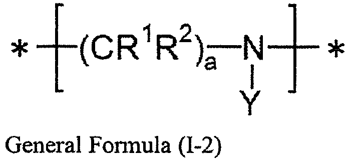

In General Formulas (I-1) and (I-2) described above, R¹ and R² each independently represent a hydrogen atom, a halogen atom, or an alkyl group. a each independently represent an integer of 1 to 5. * represents a connecting portion between the repeating units.

X represents a group having a functional group of which pKa is less than or equal to 14.

Y represents an oligomer chain or a polymer chain having 40 to 10,000 atoms.

It is preferable that the dispersion resin 2-1 further has a repeating unit denoted by General Formula (1-3) as a copolymerization component in addition to the repeating unit denoted by General Formula (I-1) or General Formula (I-2). By using such repeating units in combination, the dispersion performance of the inorganic fine particles is further improved.

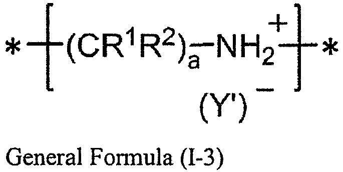

In General Formula (I-3) described above, *, R¹, R², and a are synonymous with those of General Formula (I-1).

Y' represents an oligomer chain or a polymer chain having 40 to 10,000 atoms which has an anion group.

The repeating unit denoted by General Formula (I-3) described above is able to be formed by adding an oligomer or a polymer having a group forming a salt by reacting with amine to a resin having a primary or a secondary amino group in a main chain portion, and by allowing the oligomer or the polymer to react with the resin.

In General Formula (I-1), General Formula (1-2), and General Formula (1-3), it is particularly preferable that R¹ and R² are hydrogen atoms. It is preferable that a is 2 from a viewpoint of the availability of the raw material.

The dispersion resin 2-1 may contain lower alkylene imine as a repeating unit in addition to the repeating groups denoted by General Formula (I-1), General Formula (I-2), and General Formula (1-3). As described above, the lower alkylene imine indicates alkylene imine having 1 to 5 carbon atoms. The dispersion resin 2-1 may or may not contain such a lower alkylene imine repeating unit, when the dispersion resin 2-1 contains the lower alkylene imine, it is preferable that the content of the lower alkylene imine repeating unit is 1 mol% to 70 mol% with respect to the total repeating units included in the dispersion resin 2-1. Furthermore, a group represented by X, Y, or Y' may be further bonded to a nitrogen atom in such a lower alkylene imine repeating unit. In addition, a resin including both of a repeating unit to which a group represented by X is bonded and a repeating unit to which a group represented by Y is bonded in such a main chain structure is also included in the dispersion resin 2-1.

The repeating unit denoted by General Formula (I-1) is a repeating unit containing a nitrogen atom to which the group X having the functional group of which pKa is less than or equal to 14 is bonded, and it is preferable that the content of such a repeating unit containing a nitrogen atom is 1 mol% to 80 mol% with respect to the total repeating units included in the dispersion resin 2-1 from a viewpoint of preservation stability and developing properties.

The repeating unit denoted by General Formula (1-2) is a repeating unit having an oligomer chain or a polymer chain having 40 to 10,000 atoms, and it is preferable that the content of such a repeating unit is 10 mol% to 90 mol% with respect to the total repeating units of the dispersion resin 2-1 from a viewpoint of the preservation stability.

When considering a content ratio of both repeating units, it is preferable that the repeating unit (I-1):(I-2) is in a range of 10:1 to 1:100 by a molar ratio from a viewpoint of a balance between dispersion stability and hydrophilic and hydrophobic properties.

Furthermore, the repeating unit denoted by General Formula (I-3) which is used in combination as necessary is a repeating unit in which a partial structure having an oligomer chain or a polymer chain having 40 to 10,000 atoms is ionically bonded to a nitrogen atom of a main chain, and it is preferable that the content of such a repeating unit is 0.5 mol% to 20 mol% with respect to the total repeating units of the dispersion resin 2-1 from a viewpoint of an effect.

### (Repeating Unit Denoted by General Formula (II-1) and Repeating Unit denoted by General Formula (II-2))

A repeating unit denoted by General Formula (II-1) and a repeating unit denoted by General Formula (II-2) which are other preferred constituents of the dispersion resin 2-1 will be described in detail.

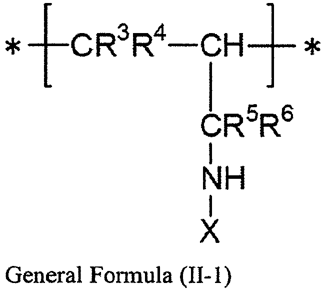

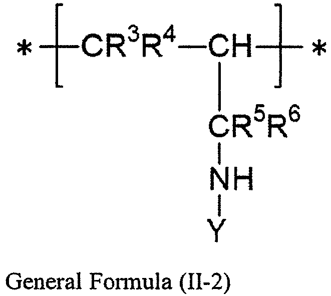

In General Formulas (II-1) and (II-2), R³, R⁴, R⁵, and R⁶ each independently represent a hydrogen atom, a halogen atom, and an alkyl group. *, X, and Y are synonymous with *, X, and Y of General Formulas (I-1) and (1-2).

It is preferable that the dispersion resin 2-1 further includes a repeating unit denoted by General Formula (II-3) as a copolymerization component in addition to the repeating unit denoted by General Formula (II-1) and the repeating unit denoted by General Formula (II-2). By using such a repeating unit in combination, the dispersion performance of the inorganic fine particles is further improved.

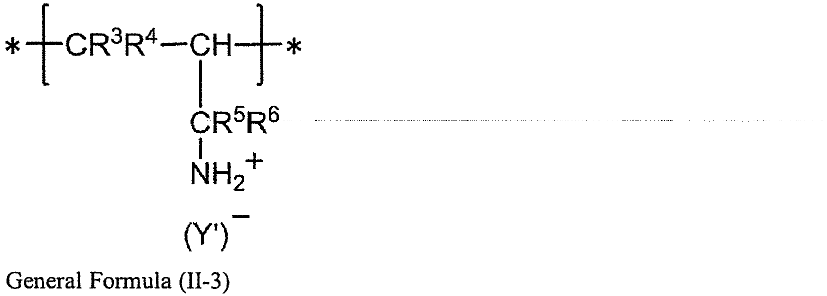

In General Formula (II-3), *, R³, R⁴, R⁵, and R⁶ are synonymous with those of General Formula (II-1). Y' is synonymous with Y' of General Formula (1-3).

In General Formulas (II-1), (II-2), and (II-3), it is preferable that R³, R⁴, R⁵, and R⁶ are hydrogen atoms from a viewpoint of the availability of the raw material.

General Formula (II-1) represents a repeating unit containing a nitrogen atom to which the group X having the functional group of which pKa is less than or equal to 14 is bonded, and it is preferable that the content of such a repeating unit containing a nitrogen atom is 1 mol% to 80 mol% with respect to the total repeating units included in the dispersion resin 2-1 from a viewpoint of the preservation stability and the developing properties.

General Formula (II-2) represents a repeating unit having an oligomer chain or a polymer chain Y having 40 to 10,000 atoms, and it is preferable that the content of such a repeating unit with respect to the total repeating units of the dispersion resin 2-1 is 10 mol% to 90 mol% from a viewpoint of the preservation stability.

When considering a content ratio of both repeating units, it is preferable that the repeating unit (II-1):(II-2) is in a range of 10:1 to 1:100 by a molar ratio from a viewpoint of the balance between the dispersion stability and the hydrophilic and hydrophobic properties.

It is preferable that the content of the repeating unit denoted by General Formula (II-3) which is used in combination as necessary is 0.5 mol% to 20 mol% with respect to the total repeating units of the dispersion resin 2-1.

In particular, it is most preferable that the dispersion resin 2-1 includes both of the repeating unit denoted by General Formula (I-1) and the repeating unit denoted by General Formula (I-2) from a viewpoint of the dispersibility.

### (Group X Having Functional Group of Less than or Equal to pKa 14)

X has a functional group of which pKa is less than or equal to 14 at a water temperature of 25°C. The structure or the like of the "functional group of which pKa is less than or equal to 14" is not particularly limited insofar as the physical properties satisfy the conditions, but a known functional group of which pKa satisfies the range described above is included, and in particular, a functional group of which pKa is less than or equal to 12 is preferable, and a functional group of which pKa is less than or equal to 11 is most preferable. Specifically, for example, a carboxylic acid (pKa is approximately 3 to 5), a sulfonic acid (pKa is approximately -3 to -2), -COCH₂CO- (pKa is approximately 8 to 10), -COCH₂CN (pKa is approximately 8 to 11), -CONHCO-, a phenolic hydroxyl group, -R_{F}CH₂OH or -(R_{F})₂CHOH (R_{F} represents a perfluoroalkyl group, and pKa is approximately 9 to 11), a sulfonamide group (pKa is approximately 9 to 11), and the like are included.

By setting pKa of the functional group included in the group X described above to be less than or equal to 14, it is possible to attain the interaction between the inorganic fine particles.

It is preferable that the group X having the functional group of which pKa is less than or equal to 14 is directly bonded to a nitrogen atom of a repeating unit containing the nitrogen atom, and the nitrogen atom of the repeating unit containing the nitrogen atom and the group X may be covalently bonded, and also may be connected through ion bonding such that a salt is formed.

In the present invention, as the group X containing the functional group of which pKa is less than or equal to 14, a group having a structure denoted by General Formula (V-1), General Formula (V-2), or General Formula (V-3) is particularly preferable.

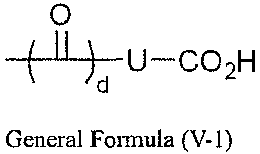

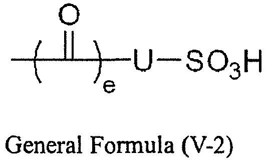

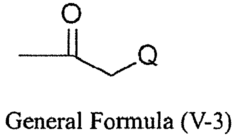

In General Formula (V-1) and General Formula (V-2) described above, U represents a single bond or a bivalent connecting group. d and e each independently represent 0 or 1.

In General Formula (V-3) described above, Q represents an acyl group or an alkoxy carbonyl group.

As the bivalent connecting group represented by U, for example, alkylene (more specifically, for example, -CH₂-, -CH₂CH₂-, -CH₂CHMe-, -(CH₂)₅-, -CH₂CH(n-C₁₀H₂₁)-, and the like), alkylene containing oxygen (more specifically, for example, -CH₂OCH₂-, -CH₂CH₂OCH₂CH₂-, and the like), an arylene group (for example, phenylene, tolylene, biphenylene, naphthylene, furanylene, pyrrolylene, and the like), alkylene oxy (for example, ethylene oxy, propylene oxy, phenylene oxy, and the like), an alkenylene group (for example, a vinylene group), and the like are included. In addition, it is preferable that d is 1, and e is 0 from a viewpoint of productivity.

Q represents an acyl group or an alkoxy carbonyl group. In particular, it is preferable that Q is an acyl group, and an acetyl group is preferable from a viewpoint of the ease of manufacturing and the availability of the raw material (a precursor X' of X).

It is preferable that the group X in the present invention is bonded to the nitrogen atom of the repeating unit containing the nitrogen atom. Accordingly, the dispersibility and the dispersion stability of the inorganic fine particles are dramatically improved.

Further, the group X includes the functional group of which pKa is less than or equal to 14 as a partial structure, and thus also functions as an alkali-soluble group. Accordingly, it is considered that the developing properties of an uncured region with respect to an alkali developer are improved, and it is possible to make the dispersibility, the dispersion stability, and the developing properties compatible.

The content of the functional group of which pKa is less than or equal to 14 in X is not particularly limited, and it is preferable that the content thereof is 0.01 mmol to 5 mmol with respect to the dispersion resin (1 g). In this range, the dispersibility and the dispersion stability of the inorganic fine particles are improved, and an uncured portion has excellent developing properties. In addition, from a viewpoint of an acid value, it is preferable that the functional group is included such that the acid value of the dispersion resin is approximately 5 mgKOH/g to 50 mgKOH/g from a viewpoint of the developing properties.

### (Oligomer Chain or Polymer Chain Y Having 40 to 10,000 Atoms)

As Y, a known polymer chain such as polyester, polyamide, polyimide, and poly(meth)acrylic ester which are able to be connected to the main chain portion of the dispersion resin is included. It is preferable that a bonding portion between Y and the dispersion resin is a terminal of the oligomer chain or the polymer chain Y.

It is preferable that Y is bonded to the nitrogen atom of at least one repeating unit containing the nitrogen atom selected from the poly(lower alkylene imine)-based repeating unit, the polyallyl amine-based repeating unit, the polydiallyl amine-based repeating unit, the meta-xylene diamine-epichlorohydrin polycondensation-based repeating unit, and the polyvinyl amine-based repeating unit. The type of bonding between Y and the nitrogen atom of at least one repeating unit containing the nitrogen atom selected from the poly(lower alkylene imine)-based repeating unit, the polyallyl amine-based repeating unit, the polydiallyl amine-based repeating unit, the meta-xylene diamine-epichlorohydrin polycondensation-based repeating unit, and the polyvinyl amine-based repeating unit, for example, includes covalent bonding, ion bonding, or a mix of covalent bonding and ion bonding. A ratio of the types of bonding between Y and the main chain portion is covalent bonding:ion bonding = 100:0 to 0:100, and is preferably 95:5 to 5:95. When the ratio is not in this range, the dispersibility and the dispersion stability deteriorate, and solvent solubility decreases.

It is preferable that Y and the nitrogen atom of the repeating unit containing the nitrogen atom are subjected to amide bonding, or subjected to ion bonding as carboxylate.

The number of atoms of the oligomer chain or the polymer chain Y is preferably 50 to 5,000, and is more preferably 60 to 3,000 from a viewpoint of the dispersibility, the dispersion stability, and the developing properties.

When the number of atoms per one oligomer chain or one polymer chain Y is less than 40, a graft chain is short, and thus a steric repulsion effect may decrease and the dispersibility may decrease. In contrast, when the number of atoms per one oligomer chain or one polymer chain Y is greater than 10000, the oligomer chain or the polymer chain Y is excessively lengthened, and thus an adsorption force with respect to the inorganic fine particles may decrease and the dispersibility may decrease.

In addition, the number average molecular weight of Y is able to be measured by a polystyrene conversion value using a GPC method. In particular, the number average molecular weight of Y is preferably 1,000 to 50,000, and is most preferably 1,000 to 30,000 from a viewpoint of the dispersibility, the dispersion stability, and the developing properties.

The number of side chain structures represented by Y which are connected to a main continuous chain is preferably more than or equal to 2, and is most preferably more than or equal to 5 in one molecule of the resin.

In particular, it is preferable that Y has a structure denoted by General Formula (III-1).

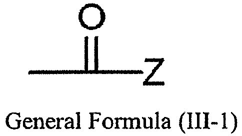

In General Formula (III-1), Z is a polymer or an oligomer having a polyester chain as a partial structure, and represents a residue obtained by excluding a carboxyl group from polyester having a free carboxylic acid denoted by General Formula (IV) described below.

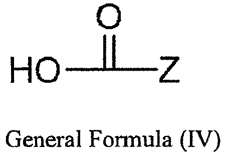

In General Formula (IV), Z is synonymous with Z in General Formula (III-1).

When the dispersion resin 2-1 contains the repeating unit denoted by General Formula (1-3) or (II-3), it is preferable that Y' has a structure denoted by General Formula (III-2).

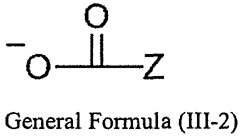

In General Formula (III-2), Z is synonymous with Z in General Formula (III-1).

Polyester having a carboxyl group on one terminal (polyester denoted by General Formula (IV)) is able to be obtained by (IV-1) polycondensation of a carboxylic acid and lactone, (IV-2) polycondensation of a hydroxy group-containing carboxylic acid, (IV-3) polycondensation of bivalent alcohol and a bivalent carboxylic acid (or a cyclic acid anhydride), and the like.

(IV-1) As the carboxylic acid used in a polycondensation reaction of the carboxylic acid and the lactone, an aliphatic carboxylic acid (preferably a straight chained or branched carboxylic acid having 1 to 30 carbon atoms), and a hydroxy group-containing carboxylic acid (preferably a straight chained or branched hydroxy group-containing carboxylic acid having 1 to 30 carbon atoms, for example, a glycolic acid, a lactic acid, a 3-hydroxy propionic acid, a 4-hydroxy dodecanoic acid, a 5-hydroxy dodecanoic acid, a ricinoleic acid, a 12-hydroxy dodecanoic acid, a 12-hydroxy stearic acid, a 2,2-bis(hydroxy methyl) butyrate, and the like) are included. As the lactone, known lactone is able to be used.

A plurality of types of lactone may be used by being mixed.

A charged molar ratio at the time of the reaction between the carboxylic acid and the lactone depends on the molecular weight of a desired polyester chain, and thus is not able to be unambiguously determined, but is preferably carboxylic acid:lactone = 1:1 to 1:1,000, and is most preferably 1:3 to 1:500.

(IV-2) The hydroxy group-containing carboxylic acid of the polycondensation of the hydroxy group-containing carboxylic acid is identical to the hydroxy group-containing carboxylic acid of (IV-1), and the preferred range thereof is also identical to that of (IV-1).

(IV-3) As the bivalent alcohol in a polycondensation reaction of the bivalent alcohol and the bivalent carboxylic acid (or a cyclic acid anhydride), straight chained or branched aliphatic diol (diol having 2 to 30 carbon atoms) is preferable.

As the bivalent carboxylic acid, a straight chained or branched bivalent aliphatic carboxylic acid (in particular, a bivalent aliphatic carboxylic acid having 1 to 30 carbon atoms is preferable) is preferable.

It is preferable that the bivalent carboxylic acid and the bivalent alcohol are charged at a molar ratio of 1:1. Accordingly, it is possible to introduce the carboxylic acid to the terminal.

It is preferable that the polycondensation at the time of manufacturing the polyester is performed by adding a catalyst thereto. As the catalyst, a catalyst which functions as Lewis acid is preferable.

The number average molecular weight of the polyester is able to be measured as a polystyrene conversion value using a GPC method. The number average molecular weight of the polyester is preferably 1,000 to 1,000,000, and is more preferably 2,000 to 100,000, and is most preferably 3,000 to 50,000. When the molecular weight is in this range, it is possible to make the dispersibility and the developing properties compatible.

In particular, it is preferable that a polyester partial structure forming a polymer chain of Y is polyester obtained by (IV-1) the polycondensation of the carboxylic acid and the lactone and (IV-2) the polycondensation of the hydroxy group-containing carboxylic acid from a viewpoint of the ease of manufacturing.

A specific type of the dispersion resins [(A-1) to (A-61)] will be described below by using a specific structure of the repeating unit of the resin and a combination thereof, but the present invention is not limited thereto. In the following formulas, k, 1, m, and n each represent a polymerization molar ratio of the repeating unit, k is 1 to 80, 1 is 10 to 90, m is 0 to 80, n is 0 to 70, and k + 1 + m + n is 100. p and q represent the number of connections of the polyester chain, and each independently represent 5 to 100,000. R' represents a hydrogen atom or an alkyl carbonyl group.

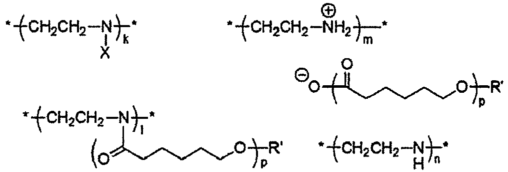

| X | | X | |
|---|---|---|---|
| (A-1) | 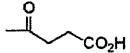 | (A-10) | 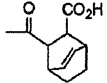 |
| (A-2) | 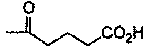 | (A-11) | 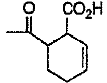 |
| (A-3) | 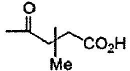 | (A-12) | 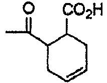 |
| (A-4) | 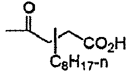 | (A-13) | 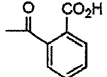 |
| (A-5) | 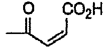 | (A-14) | 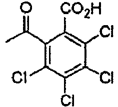 |
| (A-6) | 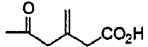 | | |
| (A-7) | 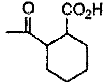 | (A-15) | 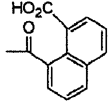 |
| (A-8) | 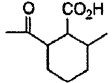 | | |
| (A-9) | 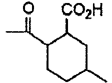 | | |

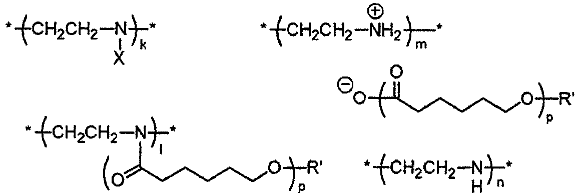

| X | | X | |
|---|---|---|---|
| (A-16) | 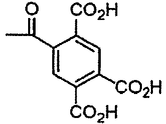 | (A-22) | 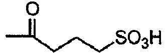 |
| | | (A-23) | 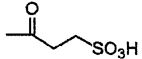 |
| (A-17) | 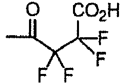 | (A-24) | 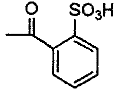 |
| (A-18) | 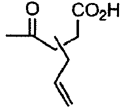 | (A-25) | -CH₂CO₂H |
| | | (A-26) | -CH₂CH₂CO₂H |
| (A-19) | 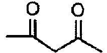 | (A-27) | 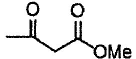 |
| (A-20) | 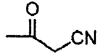 | | |
| (A-21) | 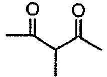 | (A-28) | 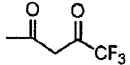 |

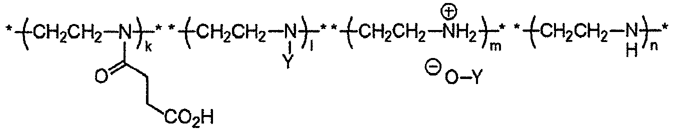

| Y | |
|---|---|
| (A-29) | 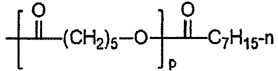 |
| (A-30) | 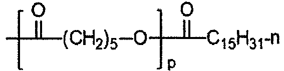 |
| (A-31) | 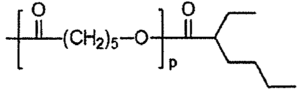 |
| (A-32) | 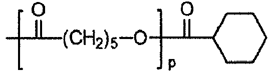 |
| (A-33) | 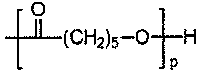 |
| (A-34) | 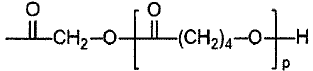 |
| (A-35) | 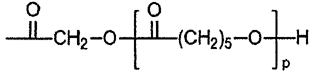 |

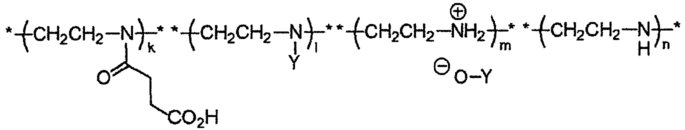

| Y | |
|---|---|
| (A-36) | 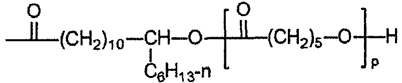 |
| (A-37) | 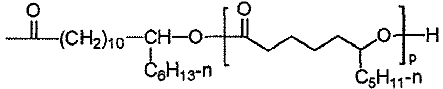 |
| (A-38) | 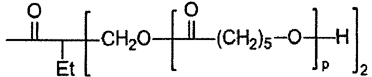 |
| (A-39) | 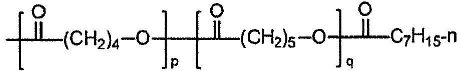 |
| (A-40) | 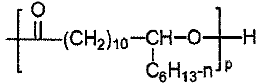 |
| (A-41) | 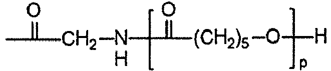 |
| (A-42) | 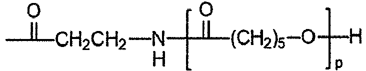 |

| | |
|---|---|
| 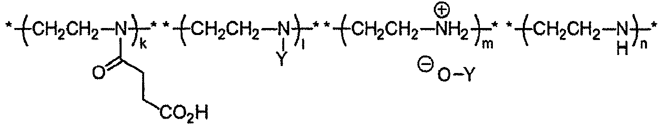 | |

| Y | |
|---|---|
| (A-43) | 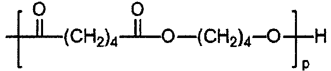 |
| (A-44) | 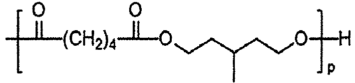 |
| (A-45) | 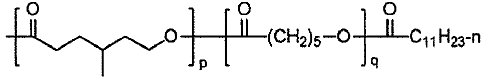 |
| (A-46) | 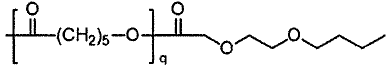 |
| (A-47) | 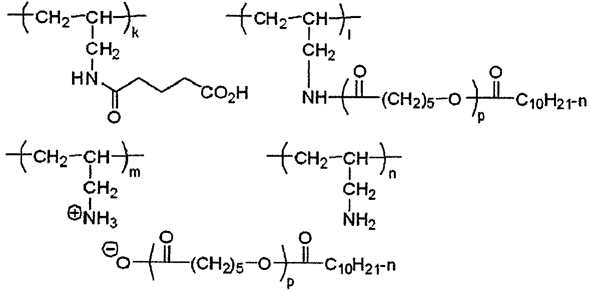 |
| (A-48) | 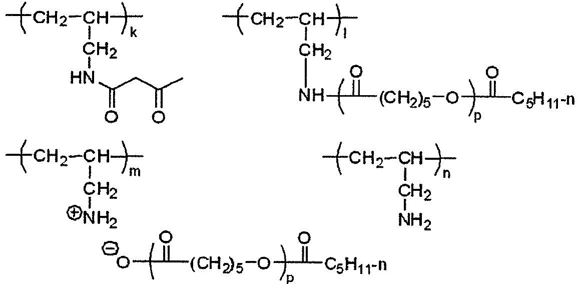 |
| (A-49) | 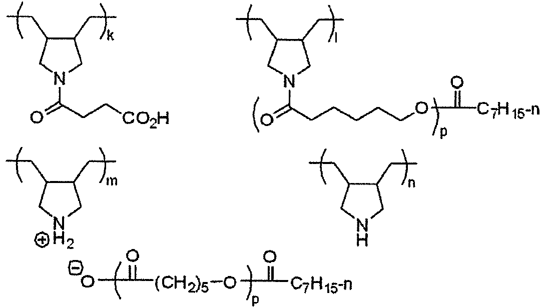 |
| (A-50) | 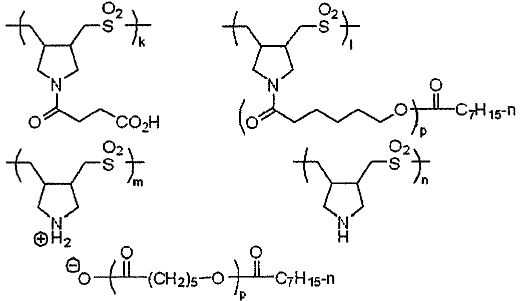 |
| (A-51) | 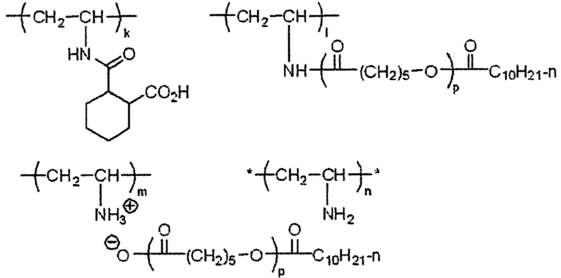 |
| (A-52) | 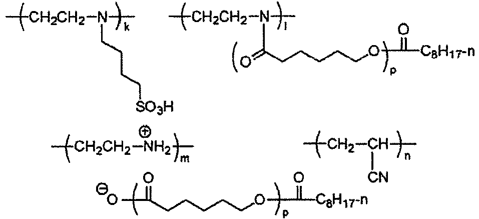 |
| (A-53) | 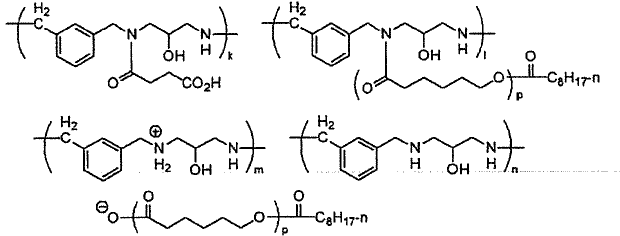 |
| (A-54) | 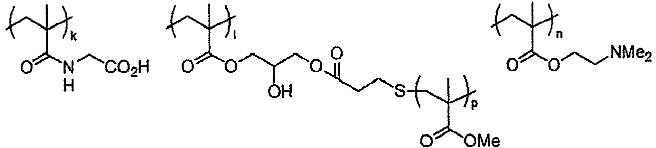 |
| (A-55) | 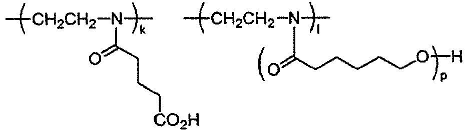 |
| (A-56) | 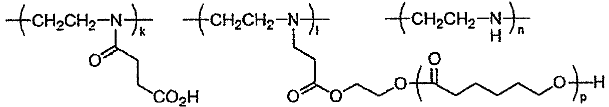 |
| (A-57) | 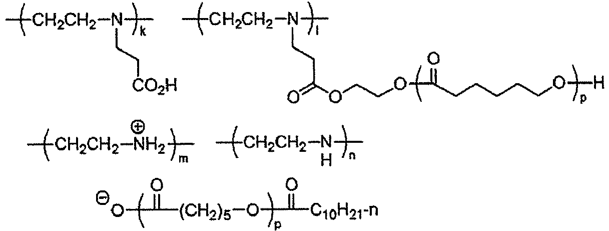 |
| (A-58) | 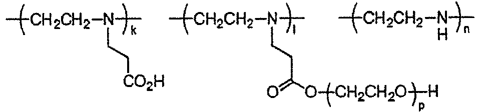 |
| (A-59) | 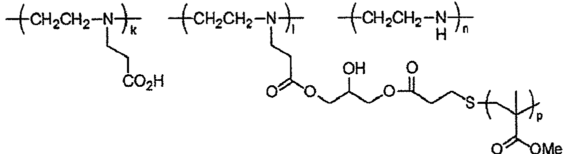 |
| (A-60) | 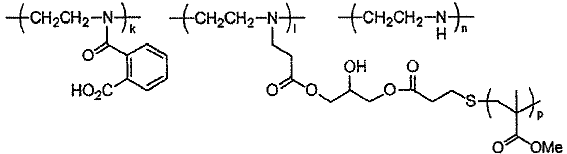 |
| (A-61) | 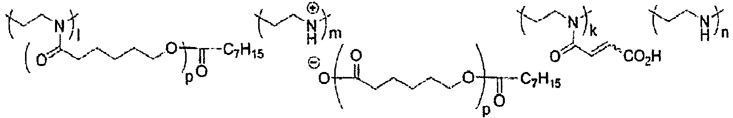 |

As a synthesizing method of the dispersion resin, a method disclosed in a publication of JP2011-190180 is able to be used.

The weight average molecular weight of the dispersion resin which is measured by using a GPC method is preferably 3,000 to 100,000, and is more preferably 5,000 to 55,000. When the molecular weight is in the range described above, there are advantages that high developing properties and high preservation stability are able to be attained. In addition, the presence or absence of the nitrogen atom of the repeating unit (i) containing the nitrogen atom in the dispersion resin is able to be confirmed by a method such as acid titration, and the presence or absence of the functional group of which pKa is less than or equal to 14 and the bonding between the functional group and the nitrogen atom of the repeating unit described above are able to be confirmed by a method such as base titration, a nuclear magnetic resonance spectroscopic method, and an infrared spectroscopic method. In addition, having (ii) the oligomer chain or the polymer chain Y having 40 to 10,000 atoms on the side chain is able to be confirmed by a method such as a nuclear magnetic resonance spectroscopic method and a GPC method.

Hereinafter, a specific example of the dispersion resin will be described along with the molecular weight. R' represents an alkyl group.

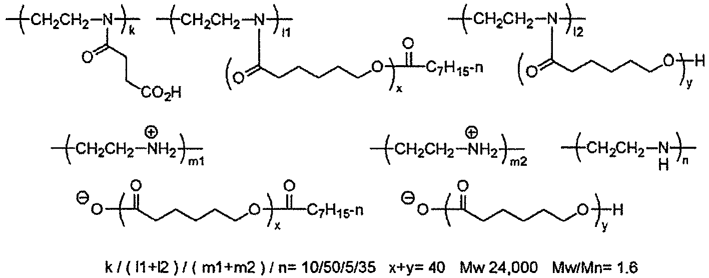

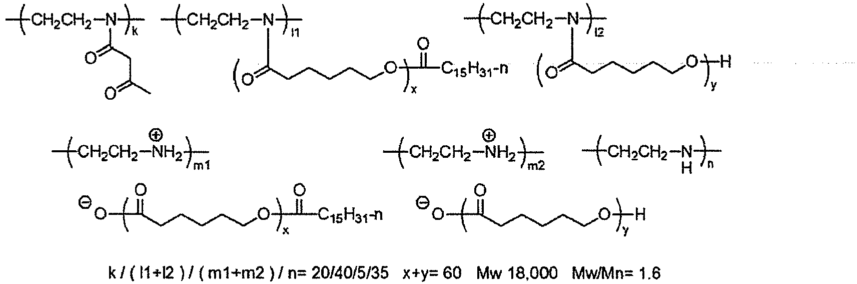

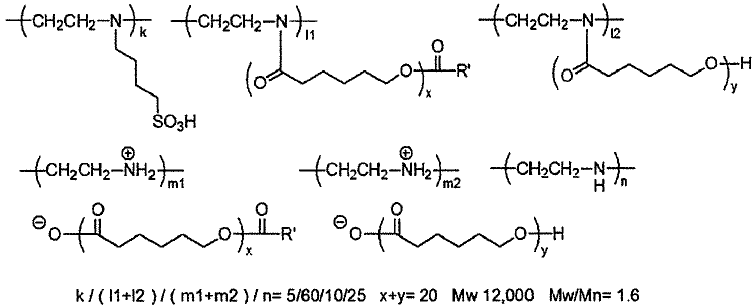

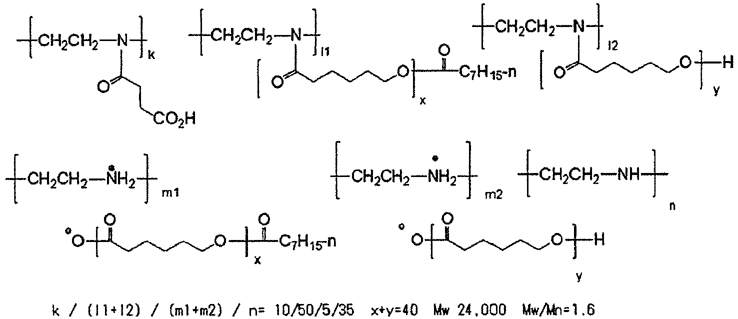

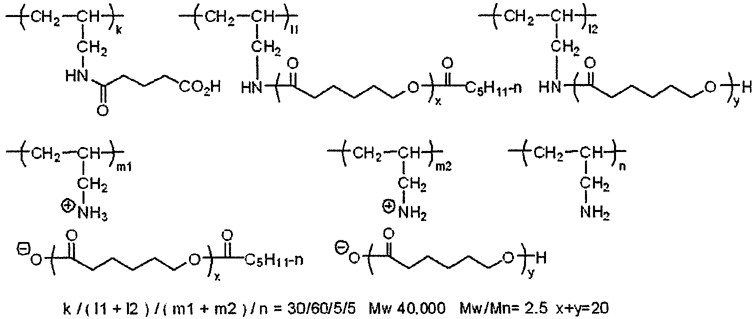

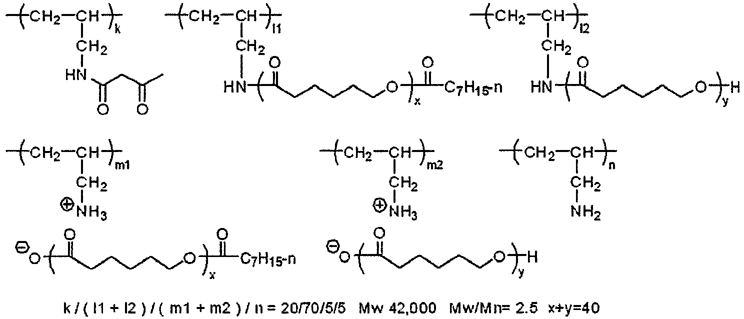

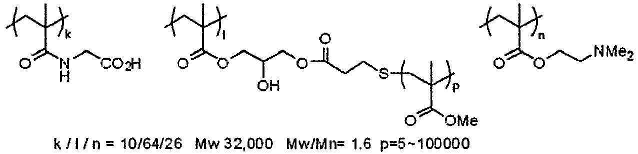

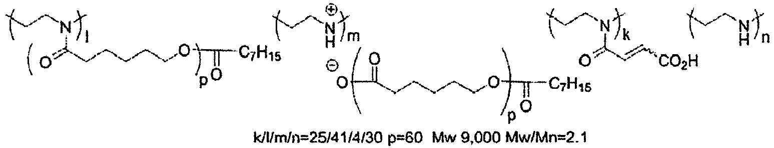

### (Polymer Compound)

As the dispersant, a polymer compound (a dispersant) denoted by General Formula (1) is preferably included.

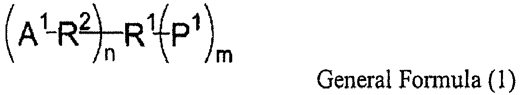

In General Formula (1) described above, R¹ represents a (m + n)-valent connecting group, and R² represents a single bond or a bivalent connecting group. A¹ represents a monovalent substituent group including at least one selected from a group consisting of an acid group, a urea group, a urethane group, a group having a coordinating oxygen atom, a group having a basic nitrogen atom, a heterocyclic group, an alkyloxycarbonyl group, an alkylaminocarbonyl group, a carboxylate group, a sulfonamide group, an alkoxysilyl group, an epoxy group, an isocyanate group, and a hydroxyl group. n A¹s and R²s may respectively identical to each other or different from each other.

m represents a positive number of less than or equal to 8, n represents 1 to 9, and m + n satisfies 3 to 10.

P¹ represents a polymer chain. m P¹s may be identical to each other or different from each other.

A monovalent substituent group A¹ of the dispersant denoted by General Formula (1) is able to interact with the inorganic fine particles. Accordingly, the dispersant denoted by General Formula (1) has n (1 to 9) substituent groups A¹, and thus is able to strongly interact with the inorganic fine particles.

In addition, m polymer chains P¹ of the dispersant denoted by General Formula (1) are able to function as a steric repulsion group, excellent steric repulsion force is able to be exhibited according to the m polymer chains P¹, and the inorganic fine particles are able to be homogeneously dispersed. Further, it is assumed that the dispersant denoted by General Formula (1) in a molecular structure does not have a negative effect that particles are aggregated due to a cross-linkage between the particles obtained by a dispersant having a graft random structure of the related art.

Hereinafter, each group of General Formula (1) will be described in detail. Furthermore, the dispersant denoted by General Formula (1) is identical to the dispersant disclosed in JP2007-277514A (JP2006-269707), and the contents and the preferred structure described in JP2007-277514A (JP2006-269707) are applied to the following description, and thus the repeated description will be suitably omitted.

A¹ represents a monovalent substituent group having at least one functional group having adsorption performance with respect to the inorganic fine particles, such as an acid group, a group having a basic nitrogen atom, a urea group, a urethane group, a group having a coordinating oxygen atom, a heterocyclic group, an alkyloxycarbonyl group, an alkylaminocarbonyl group, a carboxylate group, a sulfonamide group, an alkoxysilyl group, an epoxy group, an isocyanate group, and a hydroxyl group.

Furthermore, hereinafter, a portion having adsorption performance with respect to the inorganic fine particles (the functional group described above) will be suitably and collectively referred to as an "adsorption portion", and then will be described.

At least one adsorption portion may be included in one A¹, or two or more thereof may be included in one A¹.

In addition, in the present invention, the "monovalent substituent group having at least one adsorption portion" is a monovalent substituent group formed by bonding the adsorption portion described above to a connecting group formed of 1 to 200 carbon atoms, 0 to 20 nitrogen atoms, 0 to 100 oxygen atoms, 1 to 400 hydrogen atoms, and 0 to 40 sulfur atoms. Furthermore, when the adsorption portion itself configures the monovalent substituent group, the adsorption portion itself may be the monovalent substituent group represented by A¹.

First, the adsorption portion configuring A¹ will be described below.

As a preferred example of the "acid group" described above, for example, a carboxylic acid group, a sulfonic acid group, a monosulfuric ester group, a phosphoric acid group, a monophosphoric ester group, and a boric acid group are included, the carboxylic acid group, the sulfonic acid group, the monosulfuric ester group, the phosphoric acid group, and the monophosphoric ester group are more preferable, the carboxylic acid group, the sulfonic acid group, and the phosphoric acid group are even more preferable, and the carboxylic acid group is particularly preferable.

As a preferred example of the "urea group", for example, -NR¹⁵CONR¹⁶R¹⁷ (here, R¹⁵, R¹⁶, and R¹⁷ each independently represent a hydrogen atom, an alkyl group having 1 to 20 carbon atoms, an aryl group having 6 or greater carbon atoms, or an aralkyl group having 7 or greater carbon atoms) is included, -NR¹⁵CONHR¹⁷ (here, R¹⁵ and R¹⁷ each independently represent a hydrogen atom, an alkyl group having 1 to 10 carbon atoms, an aryl group having 6 or greater carbon atoms, and an aralkyl group having 7 or greater carbon atoms) is more preferable, and -NHCONHR¹⁷ (here, R¹⁷ represents a hydrogen atom, an alkyl group having 1 to 10 carbon atoms, an aryl group having 6 or greater carbon atoms, and an aralkyl group having 7 or greater carbon atoms) is particularly preferable.

As a preferred example of the "urethane group", for example, -NHCOOR¹⁸, -NR¹⁹COOR²⁰, -OCONHR²¹, -OCONR²²R²³ (here, R¹⁸, R¹⁹, R²⁰, R²¹, R²², and R²³ each independently represent an alkyl group having 1 to 20 carbon atoms, an aryl group having 6 or greater carbon atoms, and an aralkyl group having 7 or greater carbon atoms), and the like are included, -NHCOOR¹⁸, -OCONHR²¹ (here, R¹⁸ and R²¹ each independently represent an alkyl group having 1 to 20 carbon atoms, an aryl group having 6 or greater carbon atoms, and an aralkyl group having 7 or greater carbon atoms), and the like are more preferable, and -NHCOOR¹⁸, -OCONHR²¹ (here, R¹⁸ and R²¹ each independently represent an alkyl group having 1 to 10 carbon atoms, an aryl group having 6 or greater carbon atoms, and an aralkyl group having 7 or greater carbon atoms), and the like are particularly preferable.

As the "group having a coordinating oxygen atom", for example, an acetyl acetonato group, crown ether, and the like are included.

As a preferred example of the "group having a basic nitrogen atom", for example, an amino group (-NH₂), a substituted imino group (-NHR⁸ and -NR⁹R¹⁰, where R⁸, R⁹, and R¹⁰ each independently represent an alkyl group having 1 to 20 carbon atoms, an aryl group having 6 or greater carbon atoms, and an aralkyl group having 7 or greater carbon atoms), a guanidyl group denoted by Formula (a1) described below, an amidinyl group denoted by Formula (a2) described below, and the like are included.

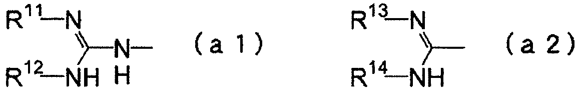

In Formula (a1), R¹¹ and R¹² each independently represent an alkyl group having 1 to 20 carbon atoms, an aryl group having 6 or greater carbon atoms, or an aralkyl group having 7 or greater carbon atoms.

In Formula (a2), R¹³ and R¹⁴ each independently represent an alkyl group having 1 to 20 carbon atoms, an aryl group having 6 or greater carbon atoms, or an aralkyl group having 7 or greater carbon atoms.

Among them, the amino group (-NH₂), a substituted imino group (-NHR⁸ and -NR⁹R¹⁰, where R⁸, R⁹, and R¹⁰ each independently represent an alkyl group, a phenyl group, or a benzyl group having 1 to 10 carbon atoms), a guanidyl group denoted by Formula (a1) [in Formula (a1), R¹¹ and R¹² each independently represent an alkyl group, a phenyl group, and a benzyl group having 1 to 10 carbon atoms], or an amidinyl group denoted by Formula (a2) [in Formula (a2), R¹³ and R¹⁴ each independently represent an alkyl group, a phenyl group, and a benzyl group having 1 to 10 carbon atoms], and the like are more preferable.

In particular, the amino group (-NH₂), a substituted imino group (-NHR⁸, -NR⁹R¹⁰, and here, R⁸, R⁹, and R¹⁰ each independently represent an alkyl group, a phenyl group, or a benzyl group having 1 to 5 carbon atoms), a guanidyl group denoted by Formula (a1) [in Formula (a1), R¹¹ and R¹² each independently represent an alkyl group, a phenyl group, or a benzyl group having 1 to 5 carbon atoms], or an amidinyl group denoted by Formula (a2) [in Formula (a2), R¹³ and R¹⁴ each independently represent an alkyl group, a phenyl group, or a benzyl group having 1 to 5 carbon atoms], and the like are preferably used.

As an alkyl group portion of the "alkyloxycarbonyl group", an alkyl group having 1 to 20 carbon atoms is preferable, and for example, a methyl group, an ethyl group, and the like are included.

As an alkyl group portion of the "alkylaminocarbonyl group", an alkyl group having 1 to 20 carbon atoms is preferable, and for example, a methyl group, an ethyl group, a propyl group, and the like are included.

As the "carboxylate group", a group formed of an ammonium salt of a carboxylic acid, and the like are included.

As the "sulfonamide group", a sulfonamide group may be included in which a hydrogen atom bonded to a nitrogen atom is substituted with an alkyl group (a methyl group, and the like), an acyl group (an acetyl group, a trifluoroacetyl group, and the like), and the like.

As a preferred example of the "heterocyclic group", for example, a thiophene group, a furane group, a xanthene group, a pyrrole group, a pyrroline group, a pyrrolidine group, a dioxolan group, a pyrazole group, a pyrazoline group, a pyrazolidine group, an imidazole group, an oxazole group, a thiazole group, an oxadiazole group, a triazole group, a thiadiazole group, a pyran group, a pyridine group, a piperidine group, a dioxane group, a morpholine group, a pyridazine group, a pyrimidine group, a piperazine group, a triazine group, a trithiane group, an isoindoline group, an isoindolinone group, a benzimidazolone group, a benzothiazole group, an imide group such as a succinimide group, a phthalimide group, and naphthalimide group, a hydantoin group, an indole group, a quinoline group, a carbazole group, an acridine group, an acridone group, and an anthraquinone group are included.

Furthermore, the "heterocyclic group" may further have a substituent group, and as the substituent group, for example, an alkyl group having 1 to 20 carbon atoms such as a methyl group and an ethyl group, an aryl group having 6 to 16 carbon atoms such as a phenyl group and a naphthyl group, an acyl oxy group having 1 to 6 carbon atoms such as a hydroxyl group, an amino group, a carboxyl group, a sulfonamide group, N-sulfonyl amide group, and an acetoxy group, an alkoxy group having 1 to 20 carbon atoms such as a methoxy group and an ethoxy group, a halogen atom such as chlorine and bromine, an alkoxy carbonyl group having 2 to 7 carbon atoms such as a methoxy carbonyl group, an ethoxy carbonyl group, and a cyclohexyl oxy carbonyl group, a carbonate ester group such as a cyano group and t-butyl carbonate, and the like are included.

As the "alkoxysilyl group", any one of a monoalkoxysilyl group, a dialkoxysilyl group, and a trialkoxysilyl group may be included, but the trialkoxysilyl group is preferable, and for example, a trimethoxy silyl group, a triethoxy silyl group, and the like are included.

As the "epoxy group", a substituted or unsubstituted oxirane group (an ethylene oxide group) is included.

As the connecting group bonded to the adsorption portion, a single bond, or a connecting group formed of 1 to 100 carbon atoms, 0 to 10 nitrogen atoms, 0 to 50 oxygen atoms, 1 to 200 hydrogen atoms, and 0 to 20 sulfur atoms is preferable, and this organic connecting group may further have an unsubstituted group or a substituent group.

In the above description, as A¹, a monovalent substituent group having at least one selected from a group consisting of an acid group, a urea group, a urethane group, a sulfonamide group, an imide group, and a group having a coordinating oxygen atom is preferable.

In particular, it is preferable that A¹ is a monovalent substituent group having at least one functional group of which pKa is 5 to 14 from a viewpoint of excellent interaction with respect to the inorganic fine particles and a reduction in the viscosity of the composition.

Here, "pKa" is defined by Chemistry Handbook (II) (Revision 4th Edition, 1993, published by The Chemical Society of Japan, Maruzen Co., Ltd.).

As the functional group of which pKa is 5 to 14, a urea group, a urethane group, a sulfonamide group, an imide group, or a group having a coordinating oxygen atom is included.

Specifically, for example, a urea group (pKa is approximately 12 to 14), a urethane group (pKa is approximately 11 to 13), -COCH₂CO- as a coordinating oxygen atom (pKa is approximately 8 to 10), a sulfonamide group (pKa is approximately 9 to 11), and the like are included.

It is preferable that A¹ is represented as a monovalent substituent group denoted by General Formula (4) described below.

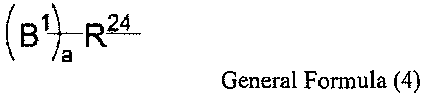

In General Formula (4), B¹ represents the adsorption portion described above, and R²⁴ represents a single bond or a (a + 1) valent connecting group. a represents an integer of 1 to 10, and a B¹s which exist in General Formula (4) may be identical to each other or different from each other.

As the adsorption portion represented by B¹, an adsorption portion identical to the adsorption portion configuring A¹ of General Formula (1) described above is included, and a preferred example thereof is also identical to that of A¹.

Among them, the acid group, the urea group, the urethane group, the sulfonamide group, the imide group, or the group having a coordinating oxygen atom is preferable, and the urea group, the urethane group, the sulfonamide group, the imide group, or the group having a coordinating oxygen atom is more preferable from a viewpoint that the functional group of which pKa is 5 to 14 is more preferable.

R²⁴ represent a single bond or a (a + 1) valent connecting group, and a represents 1 to 10. a is preferably 1 to 7, is more preferably 1 to 5, and is particularly preferably 1 to 3.

As the (a + 1) valent connecting group, a group formed of 1 to 100 carbon atoms, 0 to 10 nitrogen atoms, 0 to 50 oxygen atoms, 1 to 200 hydrogen atoms, and 0 to 20 sulfur atoms is included, and the (a + 1) valent connecting group may further have an unsubstituted group or a substituent group.

As R²⁴, a single bond, or a (a + 1) valent connecting group formed of 1 to 50 carbon atoms, 0 to 8 nitrogen atoms, 0 to 25 oxygen atoms, 1 to 100 hydrogen atoms, and 0 to 10 sulfur atoms is preferable, a single bond, or a (a + 1) valent connecting group formed of 1 to 30 carbon atoms, 0 to 6 nitrogen atoms, 0 to 15 oxygen atoms, 1 to 50 hydrogen atoms, and 0 to 7 sulfur atoms is more preferable, and a single bond, or a (a + 1) valent connecting group formed of 1 to 10 carbon atoms, 0 to 5 nitrogen atoms, 0 to 10 oxygen atoms, 1 to 30 hydrogen atoms, and 0 to 5 sulfur atoms is particularly preferable.

In the above description, when the (a + 1) valent connecting group has a substituent group, as the substituent group, for example, an alkyl group having 1 to 20 carbon atoms such as a methyl group and an ethyl group, an aryl group having 6 to 16 carbon atoms such as a phenyl group and a naphthyl group, an acyl oxy group having 1 to 6 carbon atoms such as a hydroxyl group, an amino group, a carboxyl group, a sulfonamide group, a N-sulfonyl amide group, and an acetoxy group, an alkoxy group having 1 to 6 carbon atoms such as a methoxy group, and an ethoxy group, a halogen atom such as chlorine and bromine, an alkoxy carbonyl group having 2 to 7 carbon atoms such as a methoxy carbonyl group, an ethoxy carbonyl group, and a cyclohexyl oxy carbonyl group, a carbonate ester group such as a cyano group and t-butyl carbonate, and the like are included.

In General Formula (1), R² represents a single bond or a bivalent connecting group. n R²s may be identical to each other or different from each other.

As the bivalent connecting group, a group formed of 1 to 100 carbon atoms, 0 to 10 nitrogen atoms, 0 to 50 oxygen atoms, 1 to 200 hydrogen atoms, and 0 to 20 sulfur atoms is included, and the bivalent connecting group may further have an unsubstituted group or a substituent group.

As R², a single bond, or a bivalent connecting group formed of 1 to 50 carbon atoms, 0 to 8 nitrogen atoms, 0 to 25 oxygen atoms, 1 to 100 hydrogen atoms, and 0 to 10 sulfur atoms is preferable, a single bond, or a bivalent connecting group formed of 1 to 30 carbon atoms, 0 to 6 nitrogen atoms, 0 to 15 oxygen atoms, 1 to 50 hydrogen atoms, and 0 to 7 sulfur atoms is more preferable, and a single bond, or a bivalent connecting group formed of 1 to 10 carbon atoms, 0 to 5 nitrogen atoms, 0 to 10 oxygen atoms, 1 to 30 hydrogen atoms, and 0 to 5 sulfur atoms is particularly preferable.

In the above description, when the bivalent connecting group has a substituent group, as the substituent group, for example, an alkyl group having 1 to 20 carbon atoms such as a methyl group and an ethyl group, an aryl group having 6 to 16 carbon atoms such as a phenyl group and a naphthyl group, an acyl oxy group having 1 to 6 carbon atoms such as a hydroxyl group, an amino group, a carboxyl group, a sulfonamide group, a N-sulfonyl amide group, and an acetoxy group, an alkoxy group having 1 to 6 carbon atoms such as a methoxy group and an ethoxy group, a halogen atom such as chlorine and bromine, an alkoxy carbonyl group having 2 to 7 carbon atoms such as a methoxy carbonyl group, an ethoxy carbonyl group, and a cyclohexyl oxy carbonyl group, a carbonate ester group such as a cyano group and t-butyl carbonate, and the like are included.

In General Formula (1), R¹ represents a (m + n)-valent connecting group. m + n satisfies 3 to 10.

As the (m + n)-valent connecting group represented by R¹, a group formed of 1 to 100 carbon atoms, 0 to 10 nitrogen atoms, 0 to 50 oxygen atoms, 1 to 200 hydrogen atoms, and 0 to 20 sulfur atoms is included, and the (m + n)-valent connecting group may further have an unsubstituted group or a substituent group.

As a specific example of the (m + n)-valent connecting group represented by R¹, specific examples (1) to (17) disclosed in paragraphs [0082] and [0083] of JP2007-277514A described below are included.

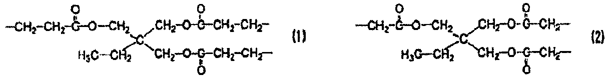

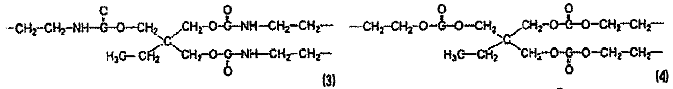

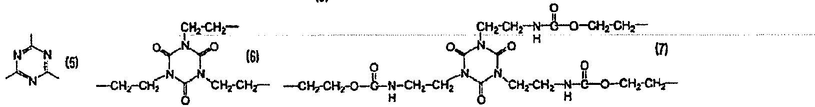

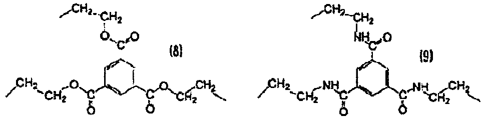

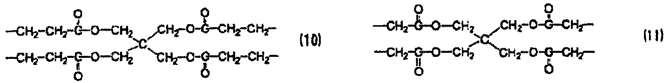

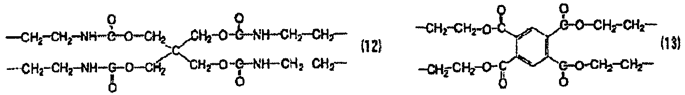

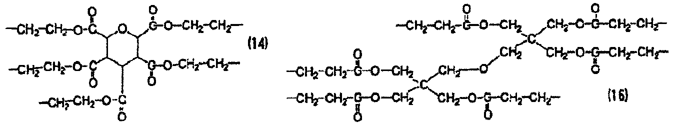

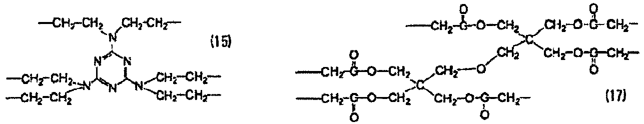

In General Formula (1), m represents a positive number of less than or equal to 8. m is preferably 0.5 to 5, is more preferably 1 to 4, and is particularly preferably 1 to 3.

In addition, in General Formula (1), n represents 1 to 9. n is preferably 2 to 8, is more preferably 2 to 7, and is particularly preferably 3 to 6.

In General Formula (1), P¹ represents a polymer chain, and is able to be selected from known polymers, and the like according to the purpose. m P¹s may be identical to each other or different from each other.

Among the polymers, in order to configure a polymer chain, at least one selected from a group consisting of a polymer or a copolymer of a vinyl monomer, an ester-based polymer, an ether-based polymer, a urethane-based polymer, an amide-based polymer, an epoxy-based polymer, a silicone-based polymer, and a modified product thereof, or a copolymer thereof [for example, a polyether/polyurethane copolymer, a polymer or a copolymer of a polyether/vinyl monomer, and the like are included (any one of a random copolymer, a block copolymer, and a graft copolymer may included)] is preferable, at least one selected from the group consisting of the polymer or the copolymer of the vinyl monomer, the ester-based polymer, the ether-based polymer, the urethane-based polymer, and the modified product thereof, or the copolymer thereof is more preferable, and the polymer or the copolymer of the vinyl monomer is particularly preferable.

It is preferable that the polymer chain P¹ contains at least one repeating unit.

The number of repeating units k of at least one repeating unit in the polymer chain P¹ is preferably greater than or equal to 3 and is more preferably greater than or equal to 5 from a viewpoint of exhibiting steric repulsion force and of improving dispersibility.

In addition, the number of repeating units k of at least one repeating unit is preferably less than or equal to 50, is more preferably less than or equal to 40, and is even more preferably less than or equal to 30 from a viewpoint of suppressing the bulkiness of the dispersant denoted by General Formula (1) and of densely arranging the inorganic fine particles in the far-infrared radiation shielding layer.

Furthermore, it is preferable that the polymer chain is soluble in an organic solvent. When the affinity of the polymer chain with respect to the organic solvent is low, the affinity with respect to a dispersion medium is weakened, and thus it is not possible to ensure an adsorptive layer which is sufficient for dispersion stabilization.

Among the dispersants denoted by General Formula (1), a dispersant denoted by General Formula (2) described below is preferable.

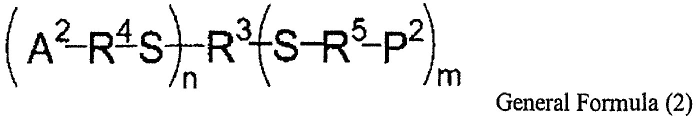

In General Formula (2), A² represents a monovalent substituent group having at least one selected from a group consisting of an acid group, a urea group, a urethane group, a group having a coordinating oxygen atom, a group having a basic nitrogen atom, an alkyloxycarbonyl group, an alkylaminocarbonyl group, a carboxylate group, a sulfonamide group, a heterocyclic group, an alkoxysilyl group, an epoxy group, an isocyanate group, and a hydroxyl group. n A²s may be identical to each other or different from each other.

Furthermore, A² is synonymous with A¹ of General Formula (1), and a preferred type thereof is also identical to that of A¹.

In General Formula (2), R⁴ and R⁵ each independently represent a single bond or a bivalent connecting group. n R⁴s may be identical to each other or different from each other. In addition, m R⁵ may be identical to each other or different from each other.

As the bivalent connecting group represented by R⁴ and R⁵, the same groups as those described as the bivalent connecting group represented by R² of General Formula (1) are used, and a preferred type thereof is also identical to that of R². More specifically, as the bivalent connecting group, a bivalent aliphatic hydrocarbon group (preferably the number of carbon atoms is 1 to 8), a bivalent aromatic hydrocarbon group (preferably the number of carbon atoms is 6 to 12), -O-, -S-, -SO₂-, -N(R)- (R: an alkyl group), -CO-, -NH-, -COO-, -CONH-, a group in which these groups are combined (for example, an alkylene oxy group, an alkylene oxy carbonyl group, an alkylene carbonyl oxy group, and the like), and the like are included.

In General Formula (2), R³ represents a (m + n)-valent connecting group. m + n satisfies 3 to 10.

As the (m + n)-valent connecting group represented by R³, a group formed of 1 to 60 carbon atoms, 0 to 10 nitrogen atoms, 0 to 50 oxygen atoms, 1 to 100 hydrogen atoms, and 0 to 20 sulfur atoms is included, and the (m + n)-valent connecting group may further have an unsubstituted group or a substituent group.

Specifically, as the (m + n)-valent connecting group represented by R³, the same groups as those described as the (m + n)-valent connecting group represented by R¹ of General Formula (1) are used, and a preferred type thereof is also identical to that of R³.

In General Formula (2), m represents a positive number of less than or equal to 8. m is preferably 0.5 to 5, is more preferably 1 to 4, and is particularly preferably 1 to 3.

In addition, in General Formula (2), n represents 1 to 9. n is preferably 2 to 8, is more preferably 2 to 7, and is particularly preferably 3 to 6.

In addition, in General Formula (2), P² represents a polymer chain, and is able to be selected from known polymers and the like according to the purpose. m P²s may be identical to each other or different from each other. A preferred type of the polymer is identical to that of P¹ of General Formula (1) described above.

Among the dispersants denoted by General Formula (2), a dispersant satisfying all the following R³, R⁴, R⁵, P², m, and n is particularly preferable.

R³: The specific example (1), (2), (10), (11), (16), or (17)

R⁴: A single bond, or a bivalent connecting group formed of "1 to 10 carbon atoms, 0 to 5 nitrogen atoms, 0 to 10 oxygen atoms, 1 to 30 hydrogen atoms, and 0 to 5 sulfur atoms", which is configured by a structure unit or in a combination thereof (a substituent group may be included, and as the substituent group, for example, an alkyl group having 1 to 20 carbon atoms such as a methyl group and an ethyl group, an aryl group having 6 to 16 carbon atoms such as a phenyl group and a naphthyl group, an acyl oxy group having 1 to 6 carbon atoms such as a hydroxyl group, an amino group, a carboxyl group, a sulfonamide group, a N-sulfonyl amide group, and an acetoxy group, an alkoxy group having 1 to 6 carbon atoms such as a methoxy group and an ethoxy group, a halogen atom such as chlorine and bromine, an alkoxy carbonyl group having 2 to 7 carbon atoms such as a methoxy carbonyl group, an ethoxy carbonyl group, and a cyclohexyl oxy carbonyl group, a carbonate ester group such as a cyano group and t-butyl carbonate, and the like are included).

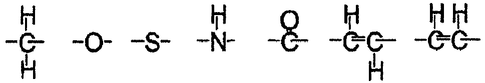

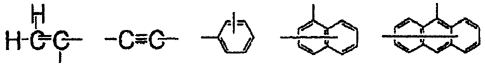

R⁵: A single bond, an ethylene group, a propylene group, Group (a) described below, or Group (b) described below

Furthermore, in the following groups, R¹² represents a hydrogen atom or a methyl group, and 1 represents 1 or 2.

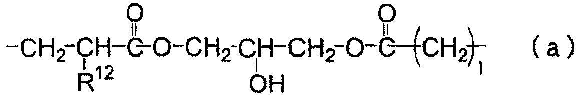

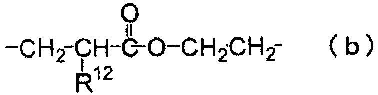

P²: A polymer or a copolymer of a vinyl monomer, an ester-based polymer, an ether-based polymer, a urethane-based polymer, and a modified product thereof
m: 1 to 3
n: 3 to 6

The acid value of the dispersant denoted by General Formula (1) or (2) is not particularly limited, and the acid value is preferably less than or equal to 400 mgKOH/g, is more preferably less than or equal to 300 mgKOH/g, and is particularly preferably less than or equal to 250 mgKOH/g from a viewpoint of the dispersibility.

Furthermore, the lower limit value of the acid value is not particularly limited, and the lower limit value is preferably greater than or equal to 5 mgKOH/g, and is more preferably greater than or equal to 10 mgKOH/g from a viewpoint of the dispersion stability of the inorganic fine particles.

Here, the acid value of the dispersant denoted by General Formula (1) or (2) is a solid content acid value.

In the present invention, the acid value of the dispersant denoted by General Formula (1) or (2), for example, is able to be calculated from the average content of the acid group in the dispersant denoted by General Formula (1) or (2).

The molecular weight of the dispersant denoted by General Formula (1) or (2) is preferably 1,000 to 50,000, is more preferably 3,000 to 30,000, and is particularly preferably 3,000 to 20,000 by the weight average molecular weight. In particular, it is most preferable that the molecular weight is less than or equal to 10,000. When the weight average molecular weight is in the range described above, the effect of a plurality of adsorption portions introduced to the terminal of the polymer is sufficiently exhibited, and thus it is possible to exhibit excellent performance in adsorptive properties with respect to the surface of the inorganic fine particles.

Furthermore, a synthesizing method of the dispersant denoted by General Formula (1) or (2) is not particularly limited, and the dispersant is able to be synthesized on the basis of a synthesizing method disclosed in paragraphs [0114] to [0140] and [0266] to [0348] of JP2007-277514A.

The content of the dispersant in the composition is not particularly limited, and the content of the dispersant is preferably 1 mass% to 90 mass%, is more preferably 3 mass% to 50 mass%, and is particularly preferably 4 mass% to 40 mass%, with respect to the total solid content mass of the composition.

Only one type of the dispersant may be used, or two or more types thereof may be used.

### <Other Components>

In the composition of the present invention, components other than the inorganic fine particles and the dispersant described above may be included.

For example, a binder polymer, a polymerizing monomer, a polymerization initiator, a surfactant, an adhesion promoter, an ultraviolet absorber, a solvent, a polymerization inhibitor, a chain transfer agent, a sensitizer, and the like are included.

Hereinafter, these components will be described in detail.

### (Binder Polymer)

It is preferable that the composition of the present invention further contains a binder polymer from a viewpoint of improving the film properties of the far-infrared radiation shielding layer to be formed.

As the binder polymer, a linear organic polymer is preferably used. As the linear organic polymer, an arbitrary known binder polymer is also able to be used. Preferably, in order to enable water development or weak alkali water development to be performed, a linear organic polymer having solubility or swelling properties with respect to water or weak alkali water is selected. The linear organic polymer is selected and used not only as a film forming agent, but also as water, weak alkali water, or an organic solvent developer according to the usage. For example, when a water soluble organic polymer is used, the water development is able to be performed. As such a linear organic polymer, a radical polymer having a carboxylic acid group on a side chain, for example, radical polymers disclosed in JP1984-44615A (JP-S59-44615A), JP1979-34327B (JP-S54-34327B), JP-1983-12577B (JP-S58-12577B), JP1979-25957B (JP-S54-25957B), JP1979-92723A (JP-S54-92723A), JP1984-53836A (JP-S59-53836A), and JP1984-71048A (JP-S59-71048A), that is, a resin in which a monomer having a carboxyl group is independently polymerized or copolymerized, a resin obtained by hydrolyzing, half esterifying, or half amidating an acid anhydride unit in which a monomer having an acid anhydride is independently polymerized or copolymerized, or epoxy acrylate in which an epoxy resin is modified by an unsaturated monocarboxylic acid and an acid anhydride, and the like are included. As the monomer having a carboxyl group, an acrylic acid, a methacrylic acid, an itaconic acid, a crotonic acid, a maleic acid, a fumaric acid, a 4-carboxyl styrene, and the like are included, and as the monomer having an acid anhydride, a maleic acid anhydride, and the like are included.

In addition, similarly, as the binder polymer, an acidic cellulose derivative having a carboxylic acid group on a side chain is included. In addition, a binder polymer in which a cyclic acid anhydride is added to a polymer having a hydroxyl group, and the like are also useful.

In the present invention, when a copolymer is used as the binder polymer, as a compound to be copolymerized, monomers other than the monomers described above are able to be used. As an example of the other monomers, the following compounds of (1) to (12) are included.
(1) Acrylic esters and methacrylic esters each having an aliphatic hydroxyl group such as 2-hydroxy ethyl acrylate, 2-hydroxy propyl acrylate, 3-hydroxy propyl acrylate, 4-hydroxy butyl acrylate, 2-hydroxy ethyl methacrylate, 2-hydroxy propyl methacrylate, 3-hydroxy propyl methacrylate, and 4-hydroxy butyl methacrylate.
(2) Alkyl acrylate such as methyl acrylate, ethyl acrylate, propyl acrylate, butyl acrylate, isobutyl acrylate, amyl acrylate, hexyl acrylate, 2-ethyl hexyl acrylate, octyl acrylate, benzyl acrylate, 2-chloroethyl acrylate, glycidyl acrylate, 3,4-epoxy cyclohexyl methyl acrylate, vinyl acrylate, 2-phenyl vinyl acrylate, 1-propenyl acrylate, allyl acrylate, 2-allyl oxy ethyl acrylate, and propargyl acrylate.
(3) Alkyl methacrylate such as methyl methacrylate, ethyl methacrylate, propyl methacrylate, butyl methacrylate, isobutyl methacrylate, amyl methacrylate, hexyl methacrylate, 2-ethyl hexyl methacrylate, cyclohexyl methacrylate, benzyl methacrylate, 2-chloroethyl methacrylate, glycidyl methacrylate, 3,4-epoxy cyclohexyl methyl methacrylate, vinyl methacrylate, 2-phenyl vinyl methacrylate, 1-propenyl methacrylate, allyl methacrylate, 2-allyl oxy ethyl methacrylate, and propargyl methacrylate.
(4) Acrylamide or methacrylamide such as acrylamide, methacrylamide, N-methylol acrylamide, N-ethyl acrylamide, N-hexyl methacrylamide, N-cyclohexyl acrylamide, N-hydroxy ethyl acrylamide, N-phenyl acrylamide, N-nitrophenyl acrylamide, N-ethyl-N-phenyl acrylamide, vinyl acrylamide, vinyl methacrylamide, N,N-diallyl acrylamide, N,N-diallyl methacrylamide, allyl acrylamide, and allyl methacrylamide.
(5) Vinyl ethers such as ethyl vinyl ether, 2-chloroethyl vinyl ether, hydroxy ethyl vinyl ether, propyl vinyl ether, butyl vinyl ether, octyl vinyl ether, and phenyl vinyl ether.
(6) Vinyl esters such as vinyl acetate, vinyl chloroacetate, vinyl butyrate, and vinyl benzoate.
(7) Styrenes such as styrene, α-methyl styrene, methyl styrene, chloromethyl styrene, and p-acetoxy styrene.
(8) Vinyl ketones such as methyl vinyl ketone, ethyl vinyl ketone, propyl vinyl ketone, and phenyl vinyl ketone.
(9) Olefins such as ethylene, propylene, isobutylene, butadiene, and isoprene.
(10) N-vinyl pyrrolidone, acrylonitrile, methacrylonitrile, and the like.
(11) Unsaturated imide such as maleimide, N-acryloyl acrylamide, N-acetyl methacrylamide, N-propionyl methacrylamide, and N-(p-chlorobenzoyl) methacrylamide.
(12) A methacrylic acid-based monomer in which a hetero atom is bonded to a α-position. For example, compounds disclosed in JP2002-309057A, JP2002-311569A, and the like are able to be included.

In the present invention, these monomers are not particularly limited, but are combined within the range of the present invention, and thus are able to be applied to the synthesis of a copolymer. For example, an example of a copolymer in which a monomer component including these monomers is polymerized will be described below, but the present invention is not limited thereto. The compositional ratio of the following examplary compounds is mol%.

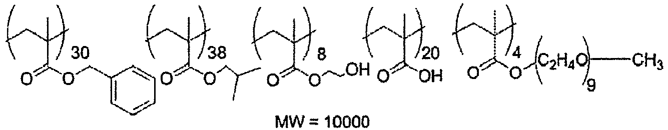

It is preferable that a repeating unit formed by polymerizing a monomer component of a compound denoted by General Formula (ED) described below (hereinafter, referred to as an "ether dimer") is included in the binder polymer.

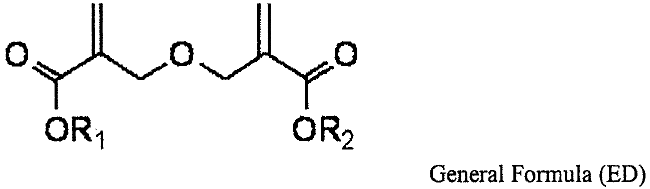

In Formula (ED), R₁ and R₂ each independently represent a hydrogen atom or a hydrocarbon group having 1 to 25 carbon atoms which may have a substituent group.

In General Formula (ED) denoting the ether dimer, the hydrocarbon group having 1 to 25 carbon atoms represented by R₁ and R₂ which may have a substituent group is not particularly limited, and as the hydrocarbon group, for example, a straight chained or branched alkyl group such as methyl, ethyl, n-propyl, isopropyl, n-butyl, isobutyl, t-butyl, t-amyl, stearyl, lauryl, and 2-ethyl hexyl; an aryl group such as phenyl; an alicyclic group such as cyclohexyl, t-butyl cyclohexyl, dicyclopentadienyl, tricyclodecanyl, isobornyl, adamantyl, and 2-methyl-2-adamantyl; an alkyl group substituted with alkoxy such as 1-methoxy ethyl and 1-ethoxy ethyl; an alkyl group substituted with an aryl group such as benzyl; and the like are included. Among them, in particular, a substituent group of primary or secondary carbon such as methyl, ethyl, cyclohexyl, and benzyl which is rarely desorbed by an acid or heat is preferable from viewpoint of heat resistance.

As a specific example of the ether dimer, for example, dimethyl-2,2'-[oxy bis(methylene)]bis-2-propenoate, diethyl-2,2'-[oxy bis(methylene)]bis-2-propenoate, di(n-propyl)-2,2'-[oxy bis(methylene)]bis-2-propenoate, di(isopropyl)-2,2'-[oxy bis(methylene)]bis-2-propenoate, di(n-butyl)-2,2'-[oxy bis(methylene)]bis-2-propenoate, di(isobutyl)-2,2'-[oxy bis(methylene)]bis-2-propenoate, di(t-butyl)-2,2'-[oxy bis(methylene)]bis-2-propenoate, di(t-amyl)-2,2'-[oxy bis(methylene)]bis-2-propenoate, di(stearyl)-2,2'-[oxy bis(methylene)]bis-2-propenoate, di(lauryl)-2,2'-[oxy bis(methylene)]bis-2-propenoate, di(2-ethyl hexyl)-2,2'-[oxy bis(methylene)]bis-2-propenoate, di(1-methoxy ethyl)-2,2'-[oxy bis(methylene)]bis-2-propenoate, di(1-ethoxy ethyl)-2,2'-[oxy bis(methylene)]bis-2-propenoate, dibenzyl-2,2'-[oxy bis(methylene)]bis-2-propenoate, diphenyl-2,2'-[oxy bis(methylene)]bis-2-propenoate, dicyclohexyl-2,2'-[oxy bis(methylene)]bis-2-propenoate, di(t-butyl cyclohexyl)-2,2'-[oxy bis(methylene)]bis-2-propenoate, di(dicyclopentadienyl)-2,2'-[oxy bis(methylene)]bis-2-propenoate, di(tricyclodecanyl)-2,2'-[oxy bis(methylene)]bis-2-propenoate, di(isobornyl)-2,2'-[oxy bis(methylene)]bis-2-propenoate, diadamantyl-2,2'-[oxy bis(methylene)]bis-2-propenoate, di(2-methyl-2-adamantyl)-2,2'-[oxy bis(methylene)]bis-2-propenoate, and the like are included. Among them, in particular, dimethyl-2,2'-[oxy bis(methylene)]bis-2-propenoate, diethyl-2,2'-[oxy bis(methylene)]bis-2-propenoate, dicyclohexyl-2,2'-[oxy bis(methylene)]bis-2-propenoate, and dibenzyl-2,2'-[oxy bis(methylene)]bis-2-propenoate are preferable. Only one type of the ether dimer may be used, or two or more types thereof may be used. In addition, a structure derived from the compound denoted by General Formula (ED) may be obtained by copolymerizing the other monomers.

As the other monomers which are able to be copolymerized along with the ether dimer, for example, a monomer for introducing an acid group, a monomer for introducing a radical polymerizing double bond, a monomer for introducing an epoxy group, and other copolymerizing monomers are included. Only one type of the monomer may be used, or two or more types thereof may be used.

As the monomer for introducing an acid group, for example, a monomer having a carboxyl group such as a (meth)acrylic acid or an itaconic acid, a monomer having a phenolic hydroxyl group such as N-hydroxy phenyl maleimide, a monomer having a carboxylic acid anhydride group such as a maleic acid anhydride, and an itaconic acid anhydride, and the like are included. Among them, in particular, a (meth)acrylic acid is preferable.

In addition, the monomer for introducing an acid group may be a monomer which is able to apply an acid group after the polymerization, and as the monomer, for example, a monomer having a hydroxyl group such as 2-hydroxy ethyl (meth)acrylate, a monomer having an epoxy group such as glycidyl (meth)acrylate, a monomer having an isocyanate group such as 2-isocyanate ethyl (meth)acrylate, and the like are included. When the monomer for introducing a radical polymerizing double bond is used and when the monomer applying an acid group after the polymerization is used, it may be necessary to perform a treatment of applying an acid group after the polymerization. The treatment of applying an acid group after the polymerization is different according to the type of the monomer, and as the treatment, for example, the following treatments are included. When the monomer having a hydroxyl group is used, for example, a treatment of adding an acid anhydride such as a succinic acid anhydride, a tetrahydrophthalic acid anhydride, and a maleic acid anhydride is included. When the monomer having an epoxy group is used, for example, a treatment of adding a compound having an amino group and an acid group such as a N-methyl aminobenzoic acid, and N-methyl aminophenol or of adding, for example, an acid anhydride such as a succinic acid anhydride, a tetrahydrophthalic acid anhydride, and a maleic acid anhydride to, for example, a hydroxyl group which is generated after adding an acid such as a (meth)acrylic acid thereto is included. When the monomer having an isocyanate group is used, for example, a treatment of adding a compound having a hydroxyl group and an acid group such as 2-hydroxy butyric acid is included.

When a polymer formed by polymerizing a monomer component containing the compound denoted by General Formula (ED) contains the monomer for introducing an acid group, the content ratio thereof is not particularly limited, but is preferably 5 mass% to 70 mass%, and is more preferably 10 mass% to 60 mass%, with respect to the total monomer components.

As the monomer for introducing a radical polymerizing double bond, for example, a monomer having a carboxyl group such as a (meth)acrylic acid, and an itaconic acid; a monomer having a carboxylic acid anhydride group such as a maleic acid anhydride, and an itaconic acid anhydride; a monomer having an epoxy group such as glycidyl (meth)acrylate, 3,4-epoxy cyclohexyl methyl (meth)acrylate, and o-(or m- or p-)vinyl benzyl glycidyl ether; and the like are included. When the monomer for introducing a radical polymerizing double bond is used, it may be necessary to perform a treatment for applying a radical polymerizing double bond after the polymerization. The treatment for applying a radical polymerizing double bond after the polymerization is different according to the type of the monomer to be used which is able to apply a radical polymerizing double bond, and as the treatment, for example, the following treatments are included. When the monomer having a carboxyl group such as a (meth)acrylic acid, and an itaconic acid is used, a treatment of adding a compound having an epoxy group and a radical polymerizing double bond such as glycidyl (meth)acrylate, 3,4-epoxy cyclohexyl methyl (meth)acrylate, and o-(or m- or p-)vinyl benzyl glycidyl ether is included. When the monomer having a carboxylic acid anhydride group such as a maleic acid anhydride, and an itaconic acid anhydride is used, a treatment of adding a compound having a hydroxyl group and a radical polymerizing double bond such as 2-hydroxy ethyl (meth)acrylate is included. When the monomer having an epoxy group such as glycidyl (meth)acrylate, 3,4-epoxy cyclohexyl methyl (meth)acrylate, and o-(or m- or p-)vinyl benzyl glycidyl ether is used, a treatment of adding a compound having an acid group and a radical polymerizing double bond such as a (meth)acrylic acid is included.

When a polymer formed by polymerizing a monomer component containing the compound denoted by General Formula (ED) contains the monomer for introducing the radical polymerizing double bond, the content ratio thereof is not particularly limited, but is preferably 5 mass% to 70 mass%, and is more preferably 10 mass% to 60 mass%, with respect to the total monomer components.

As the monomer for introducing an epoxy group, for example, glycidyl (meth)acrylate, 3,4-epoxy cyclohexyl methyl (meth)acrylate, o-(or m- or p-)vinyl benzyl glycidyl ether, and the like are included.

When a polymer formed by polymerizing a monomer component containing the compound denoted by General Formula (ED) contains the monomer for introducing an epoxy group, the content ratio thereof is not particularly limited, but is preferably 5 mass% to 70 mass%, and is more preferably 10 mass% to 60 mass%, with respect to the total monomer components.

As the other copolymerizing monomers, for example, (meth)acrylic esters such as methyl (meth)acrylate, ethyl (meth)acrylate, n-propyl (meth)acrylate, isopropyl (meth)acrylate, n-butyl (meth)acrylate, isobutyl (meth)acrylate, t-butyl (meth)acrylate, methyl 2-ethyl hexyl (meth)acrylate, cyclohexyl (meth)acrylate, benzyl (meth)acrylate, and 2-hydroxy ethyl (meth)acrylate; an aromatic vinyl compound such as styrene, vinyl toluene, and α-methyl styrene; N-substituted maleimides such as N-phenyl maleimide, and N-cyclohexyl maleimide; butadiene or a substituted butadiene compound such as butadiene, and isoprene; ethylene or a substituted ethylene compound such as ethylene, propylene, vinyl chloride, and acrylonitrile; vinyl esters such as vinyl acetate; and the like are included. Among them, methyl (meth)acrylate, cyclohexyl (meth)acrylate, benzyl (meth)acrylate, and styrene are preferable from a viewpoint of having excellent transparency, and of rarely impairing heat resistance.

When a polymer formed by polymerizing a monomer component containing the compound denoted by General Formula (ED) contains the other copolymerizing monomers, the content ratio thereof is not particularly limited, but is preferably less than or equal to 95 mass%, and is more preferably less than or equal to 85 mass%.

The weight average molecular weight of the polymer formed by polymerizing a monomer component containing the compound denoted by General Formula (ED) is not particularly limited, but is preferably 2000 to 200000, is more preferably 5000 to 100000, is even more preferably 5000 to 20000 from a viewpoint of the viscosity of the far-infrared light shielding material composition, and the heat resistance of a coated film formed of the composition.

In addition, when the polymer formed by polymerizing the monomer component containing the compound denoted by General Formula (ED) has an acid group, an acid value is preferably 20 mgKOH/g to 500 mgKOH/g, and is more preferably 50 mgKOH/g to 400 mgKOH/g.

The polymer formed by polymerizing the monomer component containing the compound denoted by General Formula (ED) is able to be easily obtained by at least polymerizing the monomer containing the ether dimer. At this time, a cyclization reaction of the ether dimer is performed along with the polymerization, and thus a tetrahydropyran ring structure is formed.

A polymerizing method applied to the synthesis of the polymer formed by polymerizing the monomer component containing the compound denoted by General Formula (ED) is not particularly limited, but various known polymerizing methods of the related art are able to be adopted, and in particular, a solution polymerizing method is preferable. Specifically, for example, the polymer formed by polymerizing the monomer component containing the compound denoted by General Formula (ED) is able to be synthesized on the basis of a synthesizing method of a polymer (a) disclosed in JP2004-300204A.

Hereinafter, examplary compounds of the polymer formed by polymerizing the monomer component containing the compound denoted by General Formula (ED) will be described, but the present invention is not limited thereto. The compositional ratio of the following examplary compounds is mol%.

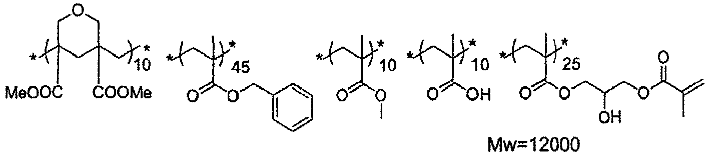

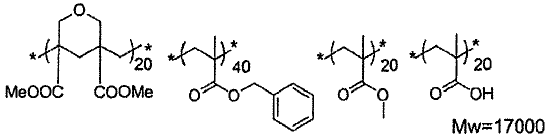

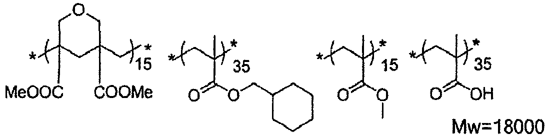

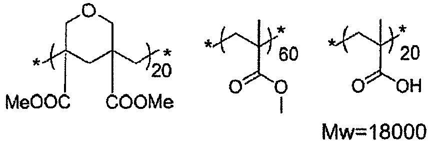

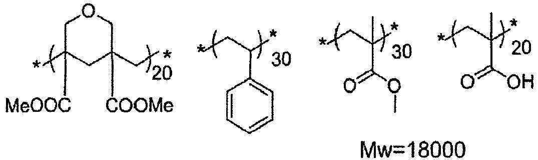

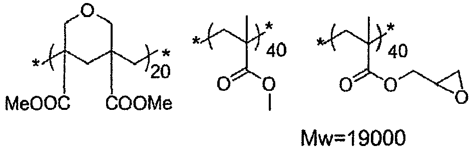

In the present invention, in particular, a polymer in which dimethyl-2,2'-[oxy bis(methylene)]bis-2-propenoate (hereinafter, referred to as "DM"), benzyl methacrylate (hereinafter, referred to as "BzMA"), methyl methacrylate (hereinafter, referred to as "MMA"), a methacrylic acid (hereinafter, referred to as "MAA"), and 2-hydroxy propylene glycol dimethacrylate (hereinafter, referred to as "X") are copolymerized is preferable. In particular, it is preferable that the molar ratio of DM:BzMA:MMA:MAA:X is 5 to 15:40 to 50:5 to 15:5 to 15:20 to 30. It is preferable that 95 mass% or more components configuring a copolymer used in the present invention are these components. In addition, it is preferable that the weight average molecular weight of this polymer is 9000 to 20000.

The weight average molecular weight of the binder polymer which is able to be used in the composition of the present invention (a polystyrene conversion value measured by a GPC method) is preferably greater than or equal to 3,000, is more preferably in a range of greater than or equal to 3000 and less than or equal to 300,000, and is more preferably in a range of greater than or equal to 3,000 and less than or equal to 150,000. Dispersity (weight average molecular weight/number average molecular weight) is preferably greater than or equal to 1, and is more preferably greater than or equal to 1.1 and less than or equal to 10.

The binder polymer may be any one of a random polymer, a block polymer, a graft polymer, and the like.

The binder polymer which is able to be used in the present invention is able to be synthesized by a known method of the related art. As a solvent used at the time of synthesizing the binder polymer, for example, tetrahydrofurane, ethylene dichloride, cyclohexanone, methyl ethyl ketone, acetone, methanol, ethanol, ethylene glycol monomethyl ether, ethylene glycol monoethyl ether, 2-methoxy ethyl acetate, diethylene glycol dimethyl ether, 1-methoxy-2-propanol, 1-methoxy-2-propyl acetate, N,N-dimethyl formamide, N,N-dimethyl acetamide, toluene, ethyl acetate, methyl lactate, ethyl lactate, dimethyl sulfoxide, water, and the like are included. These solvents may be independently used or two or more types thereof may be used by being mixed.

As a radical polymerization initiator used at the time of synthesizing the binder polymer, a known compound such as an azo-based initiator, and a peroxide initiator is included.

In the composition of the present invention, one type of the binder polymer is able to be independently used, or two or more types thereof are able to be used in combination.

As the binder polymer, Cyclomer P series such as Cyclomer P ACA230AA, and the like may be used.

When the binder polymer is contained in the composition, the content of the binder polymer is preferably 1 mass% to 60 mass%, is more preferably 3 mass% to 50 mass%, and is even more preferably 5 mass% to 45 mass%, with respect to the total solid content of the composition. By setting the content to be in the range described above, a balance between the mechanical strength and the far-infrared radiation shielding properties of the far-infrared radiation shielding layer to be formed becomes excellent.

Only one type of the binder polymer may be used, or two or more types thereof may be used.

### (Polymerizing Monomer (Polymerizing Compound))

In the composition, a polymerizing monomer may be contained. By containing the polymerizing monomer, it is possible to improve the mechanical strength of the far-infrared radiation shielding layer to be formed, and it is possible to form a pattern.

As the polymerizing monomer, it is preferable that an addition polymerizing compound having at least one ethylenically unsaturated double bond is used, and it is more preferable that a compound having at least one, and preferably two or more terminal ethylenically unsaturated bonds is used. Such a compound has been widely known in the related technical field, and in the present invention, the compound is able to be used without being particularly limited.

In addition, as the polymerizing monomer, a compound (an ethylenical compound) having an ethylenically unsaturated group which has at least one addition polymerizing ethylene group and has a boiling point of higher than or equal to 100°C under ordinary pressure is preferable. As an example thereof, monofunctional acrylate or methacrylate such as polyethylene glycol mono(meth)acrylate, polypropylene glycol mono(meth)acrylate, and phenoxy ethyl (meth)acrylate; polyethylene glycol di(meth)acrylate, trimethylol ethane tri(meth)acrylate, neopentyl glycol di(meth)acrylate, pentaerythritol tri(meth)acrylate, pentaerythritol tetra(meth)acrylate, dipentaerythritol penta(meth)acrylate, dipentaerythritol hexa(meth)acrylate, hexane diol (meth)acrylate, trimethylol propane tri(acryloyl oxy propyl) ether, tri(acryloyloxy ethyl) isocyanurate, and a mixture thereof are able to be included, and pentaerythritol tetra(meth)acrylate is preferable.

Among them, as the polymerizing monomer or the like, pentaerythritol tetraacrylate (as a marketed product, A-TMMT; manufactured by Shin-Nakamura Chemical Co., Ltd), dipentaerythritol triacrylate (as a marketed product, KAYARADD-330; manufactured by Nippon Kayaku Co., Ltd.), dipentaerythritol tetraacrylate (as a marketed product, KAYARAD D-320; manufactured by Nippon Kayaku Co., Ltd.), dipentaerythritol penta(meth)acrylate (as a marketed product, KAYARAD D-310; manufactured by Nippon Kayaku Co., Ltd.), and dipentaerythritol hexa(meth)acrylate (as a marketed product, KAYARADDPHA; manufactured by Nippon Kayaku Co., Ltd.) are preferable, and pentaerythritol tetraacrylate is more preferable.

As the polymerizing monomer, a multifunctional monomer having an acid group such as a carboxyl group, a sulfonic acid group, and a phosphoric acid group may be included. Accordingly, when the ethylenical compound has an unreacted carboxyl group as in a case where the ethylenical compound is a mixture as described above, the ethylenical compound is able to be directly used, and as necessary, the acid group may be introduced by allowing a non-aromatic carboxylic acid anhydride to react with the hydroxyl group of the ethylenical compound described above. In this case, as a specific example of the non-aromatic carboxylic acid anhydride to be used, a tetrahydrophthalic acid anhydride, alkylated tetrahydrophthalic acid anhydride, hexahydrophthalic acid anhydride, alkylated hexahydrophthalic acid anhydride, succinic acid anhydride, and maleic acid anhydride are included.

As the monomer having an acid group, a multifunctional monomer which is ester of an aliphatic polyhydroxy compound and an unsaturated carboxylic acid, and has an acid group by allowing a non-aromatic carboxylic acid anhydride to react with an unreacted hydroxyl group of an aliphatic polyhydroxy compound is preferable, and a monomer in which the aliphatic polyhydroxy compound of this ester is pentaerythritol and/or dipentaerythritol is particularly preferable. As a polybasic acid modified acryloligomer, for example, M-305, M-510, M-520, and the like of Aronix series manufactured by Toagosei Co., Ltd. as a marketed product are included.

A preferred acid value of the multifunctional monomer having an acid group is 0.1 mg-KOH/g to 40 mg-KOH/g, and is particularly preferably 5 mg-KOH/g to 30 mg-KOH/g. When two or more types of multifunctional monomers having different acid groups are used in combination, or when a multifunctional monomer not having an acid group is used in combination, it is necessary to be prepared that the acid value as the total multifunctional monomers is in the range described above.

In these polymerizing monomers, the detail of a using method such as the structure, independent use or combination use, and the added amount is able to be arbitrarily set according to the final performance design of the composition. For example, the detail is selected from the following viewpoints.

A structure having a large content of unsaturated groups per one molecule is preferable from a viewpoint of sensitivity, and when the structure has a large content of unsaturated groups per one molecule, a difunctional or higher monomer is preferable. In addition, in order to increase the strength of the far-infrared radiation shielding layer, a trifunctional or higher monomer is preferable, and monomers having different functional numbers and different polymerizing groups (for example, acrylic ester, methacrylic ester, a styrene-based compound, and a vinyl ether-based compound) are used in combination, and thus a method of adjusting both the sensitivity and the strength is also effective.

In addition, in the compatibility and the dispersibility with respect to the other components contained in the composition (for example, a polymerization initiator, inorganic fine particles, and the like), a selecting and using method of a polymerizing monomer is a major factor, and for example, the compatibility is able to be improved by using a compound with low purity, or by using two or more types of the other components in combination. In addition, in order to improve the adhesiveness with respect to a rigid surface of a substrate or the like, a specific structure is able to be selected.

When the polymerizing monomer is contained in the composition, the content of the polymerizing monomer is preferably in a range of 1 mass% to 40 mass%, is more preferably in a range of 3 mass% to 35 mass%, and is even more preferably in a range of 5 mass% to 30 mass%, with respect to the total solid content of the composition. When the content is in this range, curing properties are excellent, and thus setting the content to be in this range is preferable.

Only one type of the polymerizing monomer may be used, or two or more types of thereof may be used.

### (Polymerization Initiator)

A polymerization initiator may be contained in the composition. By containing the polymerization initiator, the curing properties are improved.

The polymerization initiator is not particularly limited insofar as the polymerization initiator has an ability of initiating the polymerization of the polymerizing monomer, and is able to be suitably selected from known polymerization initiators.

In addition, for example, a polymerization initiator having radiation-sensitive properties with respect to a visible light ray from an ultraviolet region (a photopolymerization initiator) is preferable from a viewpoint of the excellent curing in a curing treatment of the composition described below. In addition, the polymerization initiator may be an activator which interacts with a photoexcited sensitizer, and thus generates an active radical, or may be an initiator which initiates cationic polymerization according to the type of monomer.

In addition, it is preferable that the polymerization initiator contains at least one type of compound having a molecular absorption coefficient of at least approximately 50 in a range of approximately 300 nm to 800 nm (330 nm to 500 nm is more preferable).

As the polymerization initiator, an oxime-based compound is preferable, and an oxime ester-based compound is more preferable.

As a specific example of an oxime-based initiator, compounds disclosed in JP2001-233842A, compounds disclosed in JP2000-80068A, and compounds disclosed in JP2006-342166A are able to be used.

As an oxime compound such as an oxime derivative which is preferably used as the polymerization initiator, for example, 3-benzoyloxy iminobutane-2-one, 3-acetoxy iminobutane-2-one, 3-propionyl oxy iminobutane-2-one, 2-acetoxy iminopentane-3-one, 2-acetoxy imino-1-phenyl propane-1-one, 2-benzoyloxy imino-1-phenyl propane-1-one, 3-(4-toluene sulfonyl oxy) iminobutane-2-one, 2-ethoxy carbonyl oxy imino-1-phenyl propane-1-one, and the like are included.

As the oxime ester compound, compounds disclosed in J.C.S. Perkin II (1979) pp. 1653-1660), J.C.S. Perkin II (1979) pp. 156-162, Journal of Photopolymer Science and Technology (1995) pp. 202-232, Journal of Applied Polymer Science (2012) pp. 725-731, and JP2000-66385A, compounds disclosed in each of JP2000-80068A, JP2004-534797A, and JP2006-342166A, and the like are included.

In addition, as oxime ester compounds other than the oxime ester compounds described above, compounds disclosed in JP2009-519904A in which oxime is connected to a carbazole N position, compounds disclosed in US7626957B in which a hetero substituent group is introduced to a benzophenone portion, compounds disclosed in JP2010-15025A and US2009-292039A in which a nitro group is introduced to a pigment portion, ketoxime-based compounds disclosed in WO2009-131189A, compounds disclosed in US7556910B in which a triazine skeleton and an oxime skeleton are contained in the same molecule, compounds disclosed in JP2009-221114A which have the maximal absorption at 405 nm and have excellent sensitivity with respect to a g ray light source, and the like may be used.

Further, cyclic oxime compounds disclosed in JP2007-231000A and JP2007-322744A are also able to be preferably used. Among these cyclic oxime compounds, in particular, cyclic oxime compounds disclosed in JP2010-32985A and JP2010-185072A which are condensed into a carbazole pigment have high light absorption properties and have high sensitivity.

In addition, compounds disclosed in JP2009-242469A which have an unsaturated bond in a specific portion of an oxime compound are able to attain high sensitivity by reproducing an active radical from a polymerization inactive radical.

In addition, oxime compounds disclosed in JP2007-269779A which have a specific substituent group, and oxime compounds disclosed in JP2009-191061A which have a thioaryl group are included.

Among them, as the polymerization initiator, an oxime ester-based compound denoted by General Formula (A) described below is particularly preferable.

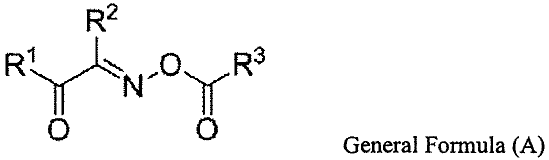

In General Formula (A) described above, R¹, R², and R³ each independently represent a monovalent substituent group.

Furthermore, an N-O bond of oxime may be an oxime compound of an (E) isomer, may be an oxime compound of a (Z) isomer, or may be a mixture of an (E) isomer and a (Z) isomer.

A monovalent substituent group with respect to R¹ is not particularly limited, and as the monovalent substituent group, an aryl group, a heterocyclic group, and the like are included. In addition, such a group may have one or more additional substituent groups.

As the aryl group, an aryl group having carbon atoms 6 to 30 is preferable, and specifically, a phenyl group, a biphenyl group, a 1-naphthyl group, a 2-naphthyl group, a 9-anthryl group, a 9-phenanthryl group, a 1-pyrenyl group, a 5-naphthacenyl group, a 1-indenyl group, a 2-azulenyl group, a 9-fluorenyl group, a terphenyl group, a quarterphenyl group, an o-tolyl group, an m-tolyl group, a p-tolyl group, a xylyl group, an o-cumenyl group, an m-cumenyl group, a p-cumenyl group, a mesityl group, a pentalenyl group, a binaphthalenyl group, a ternaphthalenyl group, a quarternaphthalenyl group, a heptalenyl group, a biphenylenyl group, an indacenyl group, a fluoranthenyl group, an acenaphthylenyl group, an aceanthrylenyl group, a phenalenyl group, a fluorenyl group, an anthryl group, a bianthracenyl group, a teranthracenyl group, a quarteranthracenyl group, an anthraquinolyl group, a phenanthryl group, a triphenylenyl group, a pyrenyl group, a chrysenyl group, a naphthacenyl group, a pleiadenyl group, a picenyl group, a perylenyl group, a pentaphenyl group, a pentacenyl group, a tetraphenylenyl group, a hexaphenyl group, a hexacenyl group, a rubicenyl group, a coronenyl group, a trinaphthylenyl group, a heptaphenyl group, a heptacenyl group, a pyranthrenyl group, and an ovalenyl group are able to be exemplified.

As the heterocyclic group, an aromatic or aliphatic hetero ring having a nitrogen atom, an oxygen atom, a sulfur atom, or a phosphorus atom is preferable.

Specifically, a thienyl group, a benzo[b] thienyl group, a naphtho[2,3-b] thienyl group, a thianthrenyl group, a furyl group, a pyranyl group, an isobenzofuranyl group, a chromenyl group, a xanthenyl group, a phenoxathiinyl group, a 2H-pyrrolyl group, a pyrrolyl group, an imidazolyl group, a pyrazolyl group, a pyridyl group, a pyrazinyl group, a pyrimidinyl group, a pyridazinyl group, an indolizinyl group, an isoindolyl group, a 3H-indolyl group, an indolyl group, a 1H-indazolyl group, a purinyl group, a 4H-quinolizinyl group, an isoquinolyl group, a quinolyl group, a phthalazinyl group, a naphthyridinyl group, a quinoxalinyl group, a quinazolinyl group, a cinnolinyl group, a pteridinyl group, a 4aH-carbazolyl group, a carbazolyl group, a β-carbolinyl group, a phenanthridinyl group, an acridinyl group, a perimidinyl group, a phenanthrolinyl group, a phenazinyl group, a phenarsazinyl group, an isothiazolyl group, a phenothiazinyl group, an isoxazolyl group, a furazanyl group, a phenoxazinyl group, an isochromanyl group, a chromanyl group, a pyrrolidinyl group, a pyrrolinyl group, an imidazolidinyl group, an imidazolinyl group, a pyrazolidinyl group, a pyrazolinyl group, a piperidinyl group, a piperazinyl group, an indolinyl group, an isoindolinyl group, a quinuclidinyl group, a morpholinyl group, and a thioxane tolyl group are able to be exemplified.

As the additional substituent group which is able to be contained in the aryl group and the heterocyclic group with respect to R¹, an alkyl group, an aryl group, an alkoxy group, an aryl oxy group, an acyl oxy group, an acyl group, an alkoxy carbonyl group, an amino group, a heterocyclic group, a halogen atom, and the like are included.

Among them, as R¹, the following Structures Sub-1 to Sub-11 are particularly preferable.

Furthermore, in the following groups, "*" indicates a bonded position with respect to the carbonyl group in General Formula (A), and each of the groups may have one or more additional substituent groups. The additional substituent groups are as described above.

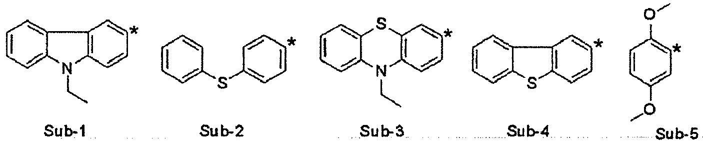

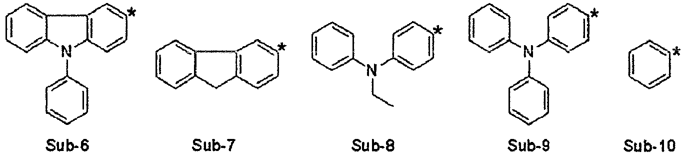

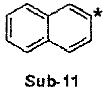

A monovalent substituent group with respect to R² is not particularly limited, and as the monovalent substituent group, an alkyl group, a cycloalkyl group, an alkynyl group, and the like are included, a monovalent substituent group having 1 to 12 carbon atoms is preferable, and an alkyl group (for example, a methyl group, an ethyl group, a propyl group, a butyl group, a hexyl group, an octyl group, a decyl group, a dodecyl group, an octadecyl group, an isopropyl group, an isobutyl group, a sec-butyl group, a t-butyl group, a 1-ethyl pentyl group, and the like) is more preferable. In addition, these groups may have one or more additional substituent groups.

As the additional substituent group which is able to be contained in the alkyl group, the cycloalkyl group, and the alkynyl group with respect to R², a hexyl group, the additional substituent groups described above as the additional substituent group which is able to be contained in the aryl group and the heterocyclic group with respect to R¹, and the like are included, an arylthio group is preferable, a substituted or unsubstituted phenylthio group is more preferable from a viewpoint that the arylthio group as the additional substituent group has high sensitivity and suppresses coloration due to heating and aging, and the following structures are even more preferable from a viewpoint of the sensitivity. Furthermore, Me represents a methyl group, Et represents an ethyl group.

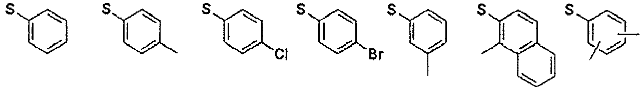

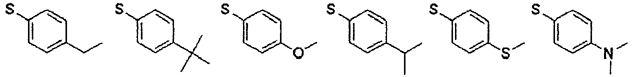

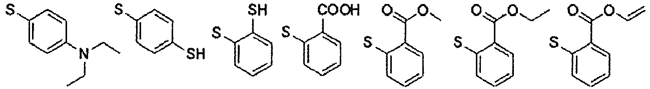

A monovalent substituent group with respect to R³ is not particularly limited, and as the monovalent substituent group, an alkyl group, an aryl group, and the like are included. In addition, these groups may have one or more additional substituent groups.

As the alkyl group with respect to R³, the alkyl groups described as the monovalent substituent group with respect to R² are included.

As the aryl group with respect to R³, the aryl groups described as the monovalent substituent group with respect to R¹ are included.

As the additional substituent group which is able to be contained in the alkyl group and the aryl group with respect to R³, the additional substituent groups described as the additional substituent group which is able to be contained in the aryl group and the heterocyclic group with respect to R¹ are included.

Specific Examples (PIox-1) to (PIox-13) of the oxime compound which is preferably used will be described below, but the present invention is not limited thereto.

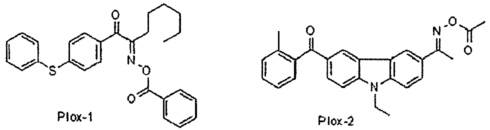

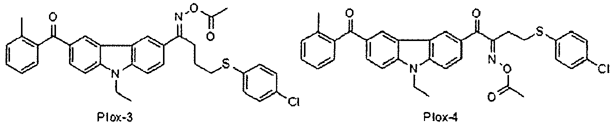

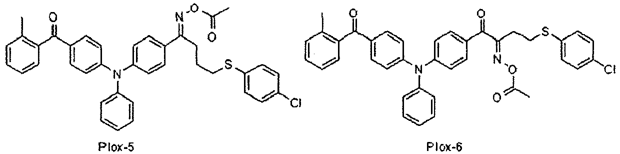

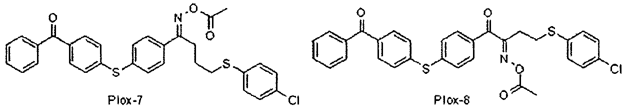

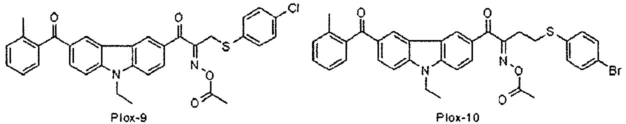

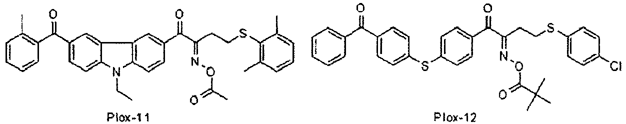

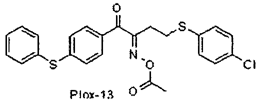

As a marketed product, IRGACURE-OXE01 (manufactured by BASF SE), and IRGACURE-OXE02 (manufactured by BASF SE) are preferably used, and IRGACURE-OXE01 (manufactured by BASF SE) is particularly preferable.

The oxime compound has the maximum absorption wavelength in a wavelength region of 350 nm to 500 nm, it is preferable that the oxime compound has the maximum absorption wavelength in a wavelength region of 360 nm to 480 nm, and it is particularly preferable that the oxime compound has high absorbancy at 365 nm and 455 nm.

The molar absorption coefficient of the oxime compound at 365 nm or 405 nm is preferably 1,000 to 300,000, is more preferably 2,000 to 300,000, and is particularly preferably 5,000 to 200,000 from a viewpoint of sensitivity.

The molar absorption coefficient of the compound is able to be measured by using a known method, and specifically, for example, it is preferable that the molar absorption coefficient of the compound is measured by a UV-visible spectrophotometer (Carry-5 spctrophotometer, manufactured by Varian Medical Systems, Inc.) using an ethyl acetate solvent at a concentration of 0.01 g/L.

Two or more types of the polymerization initiator may be used in combination as necessary.

In addition, polymerization initiators other than the oxime compound (for example, an aminoacetophenone-based initiator, and as the aminoacetophenone-based initiator, IRGACURE-907, IRGACURE-369, and IRGACURE-379 (trade names: all are manufactured by BASF SE) which are marketed products are included) are able to be used.

It may be necessary that a fine pattern is formed to have a sharp shape by using the composition of the present invention, and in such a case, it is important to perform development with curing properties without forming residue in an unexposed portion. From such a viewpoint, it is particularly preferable that the oxime compound is used as the polymerization initiator.

When the polymerization initiator is contained in the composition, the content of the polymerization initiator is preferably in a range of 0.1 mass% to 40 mass%, is more preferably in a range of 0.5 mass% to 20 mass%, and is even more preferably in a range of 1 mass% to 15 mass%, with respect to the total solid content of the composition. When the content is in this range, the curing properties become excellent, and thus setting the content to be in this range is preferable. In this range, excellent curing properties, excellent sensitivity, and excellent pattern forming properties are able to be obtained.

Only one type of the polymerization initiator may used, or two or more types thereof may be used.

### (Surfactant)

Various surfactants may be contained in the composition of the present invention from a viewpoint of further improving coating properties. As the surfactant, various surfactants such as a fluorine-based surfactant, a nonionic surfactant, a cationic surfactant, an anionic surfactant, and a silicone-based surfactant are able to be used.

In particular, the composition of the present invention contains the fluorine-based surfactant, and thus liquid properties at the time of being prepared as a coating liquid (in particular, fluidity) are further improved, and the homogeneity of a coating thickness or liquid saving properties are able to be further improved.

That is, when a film is formed by using a coating liquid to which the composition containing the fluorine-based surfactant is applied, boundary tension between a surface to be coated and the coating liquid decreases, and thus the wettability with respect to the surface to be coated is improved, and the coating properties with respect to the surface to be coated are improved. For this reason, even when a thin film of approximately a few µm is formed with a small amount of the liquid, a film having a homogeneous thickness is more preferably formed in which thickness unevenness decreases, and thus it is effective to contain the fluorine-based surfactant in the composition of the present invention.

The content rate of fluorine in the fluorine-based surfactant is preferably 3 mass% to 40 mass%, is more preferably 5 mass% to 30 mass%, and is particularly preferably 7 mass% to 25 mass%. The fluorine-based surfactant in which the content rate of fluorine is in this range is effective from a viewpoint of the thickness homogeneity of the coated film and the liquid saving properties, and has excellent solubility in the composition.

As the fluorine-based surfactant, for example, Megaface F171, Megaface F172, Megaface F173, Megaface F176, Megaface F177, Megaface F141, Megaface F142, Megaface F143, Megaface F144, Megaface R30, Megaface F437, Megaface F475, Megaface F479, Megaface F482, Megaface F554, Megaface F780, and Megaface F781 (all are manufactured by DIC Corporation), Fluorad FC430, Fluorad FC431, and Fluorad FC171 (all are manufactured by 3M Japan Limited), Surflon S-382, Surflon SC-101, Surflon SC-103, Surflon SC-104, Surflon SC-105, Surflon SC1068, Surflon SC-381, Surflon SC-383, Surflon S393, and Surflon KH-40 (all are manufactured by Asahi Glass Co., Ltd.), PF636, PF656, PF6320, PF6520, and PF7002 (manufactured by OMNOVA Solutions Inc.), and the like are included.

As the nonionic surfactant, specifically, glycerol, trimethylol propane, trimethylol ethane, and ethoxylate and propoxylate thereof (for example, glycerol propoxylate, glycerin ethoxylate, and the like), polyoxy ethylene lauryl ether, polyoxy ethylene stearyl ether, polyoxy ethylene oleyl ether, polyoxy ethylene octyl phenyl ether, polyoxy ethylene nonyl phenyl ether, polyethylene glycol dilaurate, polyethylene glycol distearate, sorbitan fatty acid ester (Pluronic L10, L31, L61, L62, 10R5, 17R2, 25R2, Tetronic 304, 701, 704, 901, 904, and 150R1 (manufactured by BASF SE), Solsperse 20000 (manufactured by The Lubrizol Corporation), and the like are included.

As the cationic surfactant, specifically, a phthalocyanine derivative (a trade name: EFKA-745, manufactured by Morishita & Co., Ltd.), an organosiloxane polymer KP341 (manufactured by Shin-Etsu Chemical Co., Ltd.), a (meth)acrylic acid-based (co)polymer polyflow No.75, No.90, and No.95 (manufactured by Kyoeisha Chemical Co., Ltd.), W001 (manufactured by Yusho Co. Ltd), and the like are included.

As the anionic surfactant, specifically, W004, W005, W017 (manufactured by Yusho Co. Ltd), and the like are included.

As the silicone-based surfactant, for example, "Toray Silicone DC3PA", "Toray Silicone SH7PA", " Toray Silicone DC11PA", " Toray Silicone SH21PA", " Toray Silicone SH28PA", " Toray Silicone SH29PA", " Toray Silicone SH30PA", and " Toray Silicone SH8400" manufactured by Dow Coming Toray Co., Ltd., "TSF-4440", "TSF-4300", "TSF-4445", "TSF-4460", and "TSF-4452" manufactured by Momentive Performance Materials Inc., "KP341 ", "KF6001 ", and "KF6002" manufactured by Shin-Etsu Chemical Co., Ltd., "BYK307", "BYK323", and "BYK330" manufactured by BYK Additives & Instruments, and the like are combined.

Only one type of the surfactant may be used, or two or more types thereof may be used.

When the surfactant is contained in the composition, the content of the surfactant is preferably 0.001 mass% to 2.0 mass%, and is more preferably 0.005 mass% to 1.0 mass%, with respect to the total mass of the composition.

Only one type of the surfactant may be used, or two or more types thereof may be used.

### (Adhesion Promoter)

An adhesion promoter may be contained in the composition of the present invention within a range not impairing the object of the present invention. By containing the adhesion promoter, the adhesiveness between a substrate on which the far-infrared radiation shielding layer is arranged and the far-infrared radiation shielding layer is further improved.

As the adhesion promoter, for example, 3-glycidyloxy propyl trimethoxy silane, 1-methacryloxy propyl methyl dimethoxy silane, 3-aminoglycidyloxy propyl triethoxy silane, 3-glycidyloxy propyl methyl dimethoxy silane, 3-aminopropyl trimethoxy silane, N-β-aminoethyl-γ-aminopropyl-methyl dimethoxy silane (a trade name of KBM-602 manufactured by Shin-Etsu Chemical Co., Ltd.), N-β-aminoethyl-γ-aminopropyl-trimethoxy silane (a trade name of KBM-603 manufactured by Shin-Etsu Chemical Co., Ltd.), N-β-aminoethyl-γ-aminopropyl-triethoxy silane (a trade name of KBE-602 manufactured by Shin-Etsu Chemical Co., Ltd.), γ-aminopropyl-trimethoxy silane (a trade name of KBM-903 manufactured by Shin-Etsu Chemical Co., Ltd.), γ-aminopropyl-triethoxy silane (a trade name of KBE-903 manufactured by Shin-Etsu Chemical Co., Ltd.), and the like are included.

In addition, compounds disclosed in paragraph number [0048] of JP2008-243945A are used.

When the adhesion promoter is contained in the composition, the content of the adhesion promoter is preferably less than or equal to 10 mass%, and is more preferably 0.005 mass% to 5 mass%, with respect to the total solid content of the composition.

Only one type of the adhesion promoter may be used, or two or more types thereof may be used.

### (Ultraviolet Absorber)

A ultraviolet absorber may be contained in the composition of the present invention within a range not impairing the object of the present invention.

As the ultraviolet absorber, a salicylate-based ultraviolet absorber, a benzophenone-based ultraviolet absorber, a benzotriazole-based ultraviolet absorber, a substituted acrylonitrile-based ultraviolet absorber, and a triazine-based ultraviolet absorber are able to be used.

As an example of the salicylate-based ultraviolet absorber, phenyl salicylate, p-octyl phenyl salicylate, p-t-butyl phenyl salicylate, and the like are included, and as an example of the benzophenone-based ultraviolet absorber, 2,2'-dihydroxy-4-methoxy benzophenone, 2,2'-dihydroxy-4,4'-dimethoxy benzophenone, 2,2',4,4'-tetrahydroxy benzophenone, 2-hydroxy-4-methoxy benzophenone, 2,4-dihydroxy benzophenone, 2-hydroxy-4-octoxy benzophenone, and the like are included.

In addition, as an example of the benzotriazole-based ultraviolet absorber, 2-(2' -hydroxy-3' ,5' -di-tert-butyl phenyl)-5-chlorobenzotriazole, 2-(2'-hydroxy-3'-tert-butyl-5'-methyl phenyl)-5-chlorobenzotriazole, 2-(2'-hydroxy-3'-tert-amyl-5'-isobutyl phenyl)-5-chlorobenzotriazole, 2-(2'-hydroxy-3'-isobutyl-5'-methyl phenyl)-5-chlorobenzotriazole, 2-(2'-hydroxy-3'-isobutyl-5'-propyl phenyl)-5-chlorobenzotriazole, 2-(2'-hydroxy-3',5'-di-tert-butyl phenyl) benzotriazole, 2-(2'-hydroxy-5'-methyl phenyl) benzotriazole, 2-[2'-hydroxy-5'-(1,1,3,3-tetramethyl) phenyl] benzotriazole, and the like are included.

As an example of the substituted acrylonitrile-based ultraviolet absorber, 2-cyano-3,3-diphenyl ethyl acrylate, 2-cyano-3,3-diphenyl-2-ethyl hexyl acrylate, and the like are included. Further, as an example of the triazine-based ultraviolet absorber, a mono(hydroxy phenyl) triazine compound such as 2-[4-[(2-hydroxy-3-dodecyl oxy propyl) oxy]-2-hydroxy phenyl]-4,6-bis(2,4-dimethyl phenyl)-1,3,5-triazine, 2-[4-[(2-hydroxy-3-tridecyl oxy propyl) oxy]-2-hydroxy phenyl]-4,6-bis(2,4-dimethyl phenyl)-1,3,5-triazine, and 2-(2,4-dihydroxy phenyl)-4,6-bis(2,4-dimethyl phenyl)-1,3,5-triazine; a bis(hydroxy phenyl) triazine compound such as 2,4-bis(2-hydroxy-4-propyl oxy phenyl)-6-(2,4-dimethyl phenyl)-1,3,5-triazine, 2,4-bis(2-hydroxy-3-methyl-4-propyl oxy phenyl)-6-(4-methyl phenyl)-1,3,5-triazine, and 2,4-bis(2-hydroxy-3-methyl-4-hexyl oxy phenyl)-6-(2,4-dimethyl phenyl)-1,3,5-triazine; a tris(hydroxy phenyl) triazine compound such as 2,4-bis(2-hydroxy-4-butoxy phenyl)-6-(2,4-dibutoxy phenyl)-1,3,5-triazine, 2,4,6-tris(2-hydroxy-4-octyl oxy phenyl)-1,3,5-triazine, and 2,4,6-tris[2-hydroxy-4-(3-butoxy-2-hydroxy propyl oxy) phenyl]-1,3,5-triazine, and the like are included.

In addition, a diethyl amino-phenyl sulfonyl-based ultraviolet absorber (a trade name: UV-503, manufactured by Daito Chemical Co., Ltd), and the like are also preferably used.

Hereinafter, specific examples of the ultraviolet absorber are described, but the present invention is not limited thereto.

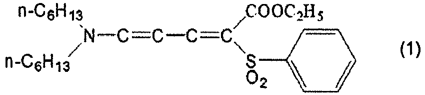

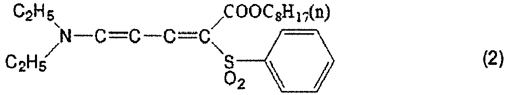

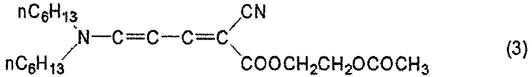

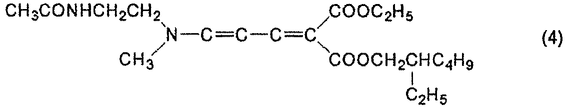

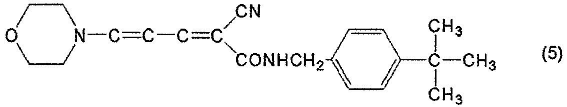

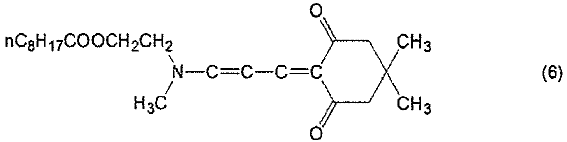

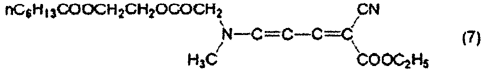

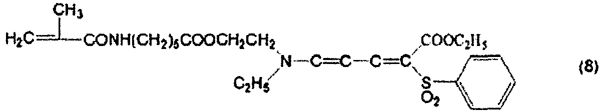

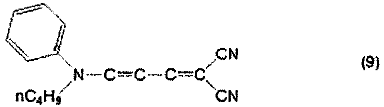

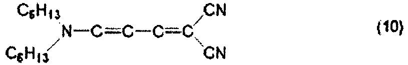

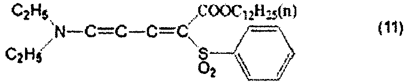

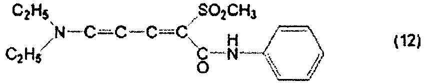

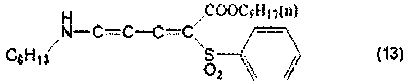

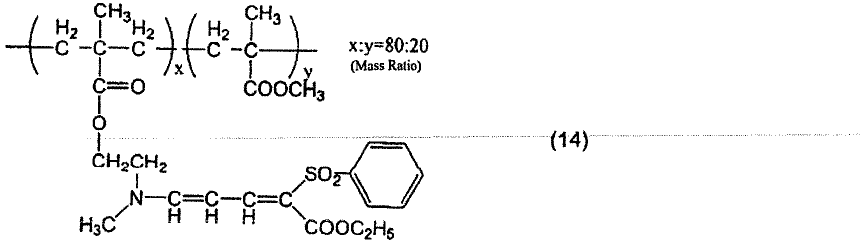

In the present invention, one type of various ultraviolet absorbers may be independently used, or two or more types thereof may be used in combination.

When the ultraviolet absorber is contained in the composition, the content of the ultraviolet absorber is preferably 0.001 mass% to 5 mass%, and is more preferably 0.01 mass% to 3 mass%, with respect to the total solid content of the composition.

Only one type of the ultraviolet absorber may be used, or two or more types thereof may be used.

### (Solvent)

A solvent may be contained in the composition of the present invention. The solvent is able to be configured by using various organic solvents.

As the organic solvent, for example, acetone, methyl ethyl ketone, cyclohexane, ethyl acetate, ethylene dichloride, tetrahydrofurane, toluene, ethylene glycol monomethyl ether, ethylene glycol monoethyl ether, ethylene glycol dimethyl ether, propylene glycol monomethyl ether, propylene glycol monoethyl ether, acetyl acetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxy propanol, methoxy methoxy ethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxy propyl acetate, N,N-dimethyl formamide, dimethyl sulfoxide, γ-butyrolactone, methyl lactate, ethyl lactate, and the like are included.

These organic solvents may be independently used or may be used by being mixed.

When the solvent is contained in the composition, the concentration of the solid content in the composition is preferably 2 mass% to 60 mass%.

Only one type of the solvent may be used, or two or more types thereof may be used.

### <Filter Filtration>

It is preferable that the composition for forming a far-infrared radiation shielding layer of the present invention is filtered by a filter in order to remove foreign substances or reduce defects.

The filter used in the filter filtration is not particularly limited, and a filter which has been used in the filtration usage or the like from the related art is able to be used.

As an example of the material of the filter, a fluorine resin such as polytetrafluoroethylene (PTFE); a polyamide-based resin such as Nylon-6, and Nylon-6,6; a polyolefin resin such as polyethylene, and polypropylene (PP) (having high density and ultrahigh molecular weight); and the like are included. Among them, polypropylene (including high density polypropylene) is preferable.

The pore diameter of the filter is not particularly limited, and for example, is approximately 0.01 µm to 20.0 µm, is preferably approximately 0.1 µm to 10 µm, and is more preferably approximately 0.1 µm to 5.0 µm.

By setting the pore diameter of the filter to be in the range described above, it is possible to more effectively remove fine particles, and it is possible to further reduce turbidity.

Here, the pore diameter of the filter is measured with reference to the nominal value of the filter manufacturer. As a commercially available filter, for example, a filter is able to be selected from various filters provided by Nihon Pall Ltd., Advantec MFS, Inc., Entegris Inc. (previously, Mykrolis Corporation), Kitz Microfilter Corporation, or the like.

In the filter filtration, two or more types of the filter may be used in combination.

For example, first, filtration is able to be performed by using a first filter, and then filtration is able to be performed by using a second filter of which the pore diameter is different from that of the first filter.

At this time, the filtering of the first filter and the filtering of the second filter may respectively performed one time, or may be performed two times or more.

As the second filter, a filter formed of the same material as that of the first filter described above is able to be used.

### <Far-Infrared Radiation Shielding Layer>

The far-infrared radiation shielding layer is formed by using the composition for forming a far-infrared radiation shielding layer containing the components described above.

A forming method of the far-infrared radiation shielding layer is not particularly limited, and as the forming method, a method is included in which the composition described above is applied onto a predetermined substrate, and as necessary, is subjected to a curing treatment.

A coating method is not particularly limited, and as the coating method, a dip coating method, an air knife coating method, a curtain coating method, a roller coating method, a wire bar coating method, a gravure coating method, a die coating method, and the like are included.

Furthermore, after the coating, as necessary, a heating and drying treatment may be performed in order to remove the solvent. The conditions of the heating and drying treatment are not particularly limited, and it is preferable that a heat treatment is performed at 50°C to 200°C (preferably 60°C to 150°C) for 30 seconds to 15 minutes (preferably 60 seconds to 5 minutes) from a viewpoint of productivity.

A method of the curing treatment is not particularly limited, and as the method, a suitable method is selected according to the components contained in the composition. As the curing treatment, an exposure treatment or a heat treatment is mainly performed.

In particular, when the polymerizing monomer is contained in the composition, and thus the far-infrared radiation shielding layer is formed into the shape of a pattern, the exposure treatment is performed, and then a development treatment for removing a unexposed portion may be performed.

Furthermore, a method of the development treatment is not particularly limited, and as the method, a method of performing the development treatment by using a developer (a solution) in which the composition of the unexposed portion is dissolved.

The layer thickness of the far-infrared radiation shielding layer to be formed is not particularly limited, but is preferably 0.1 µm to 20 µm, and is more preferably 0.5 µm to 10 µm from a viewpoint of the application with respect to an infrared array sensor or the like.

Furthermore, when the composition described above is used, it is possible to increase the concentration of the inorganic fine particles, and thus the far-infrared radiation shielding layer is able to be thinned. In particular, when a dispersion resin or the polymer compound denoted by General Formula (1) is used as the dispersant, a thin far-infrared radiation shielding layer is able to be easily manufactured.

In addition, when the composition described above is used, it is possible to more accurately form the patterned far-infrared radiation shielding layer. That is, excellent resolution is obtained. In particular, as the dispersant, when the resin or the polymer denoted by General Formula (1) described above is used, more excellent effect is obtained.

The far-infrared radiation shielding layer formed of the composition of the present invention is able to be applied to various usages. For example, an infrared array sensor is exemplified. More specifically, the far-infrared radiation shielding layer is formed on a light sensing unit of the infrared array sensor, and thus the improvement in sensitivity is expected.

In addition, the far-infrared radiation shielding layer formed of the composition described above has excellent heat capacity, alkali resistance, and scratch resistance, and thus is able to be preferably used in the infrared array sensor described above.

That is, in a case where the far-infrared radiation shielding layer described above is applied to the infrared array sensor, when the heat capacity of the far-infrared radiation shielding layer is excellent, heat generated at the time of light-heat conversion is able to be efficiently moved to a temperature measurement contact of the infrared array sensor. More specifically, as a range of the heat capacity of the far-infrared radiation shielding layer, 0.1 to 2 J/(g·K) is preferable, and 0.1 to 1.5 J/(g·K) is more preferable.

In addition, when the alkali resistance of the far-infrared radiation shielding layer is excellent, the excellent alkali resistance is preferable from a viewpoint of a process aptitude.

In addition, when the scratch resistance of the far-infrared radiation shielding layer is excellent, the excellent scratch resistance is preferable from a viewpoint of an excellent semiconductor process aptitude.

### EXAMPLES

Hereinafter, the present invention will be more specifically described with reference to examples of the present invention. Furthermore, materials, used amounts, ratios, treatment contents, treatment sequences, and the like in the following examples are able to be suitably changed within a range not departing from the gist of the present invention. Therefore, the range of the present invention will not be definitely interpreted by the following specific examples.

### [Preparation of Tin-Doped Indium Oxide Dispersion Liquid a]

28.1 parts by mass of a tin-doped indium oxide powder (P4-ITO, manufactured by Mitsubishi Materials Corporation), 18.8 parts by mass of a dispersant a (a solid content of 30%, and a solvent: propylene glycol monomethyl ether), and 28.1 parts by mass of a solvent (cyclohexanone) were mixed in advance, and then were dispersed for 5 hours dispersion by a paint shaker (manufactured by Asada Iron Works Co., Ltd.) using zirconia beads having a diameter of 0.3 mm, and thus a tin-doped indium oxide dispersion liquid a (an ITO dispersion liquid a) was prepared.

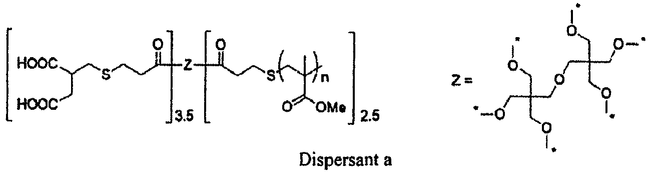

In the formula described above, n was 14, the polystyrene conversion weight average molecular weight of the dispersant a was 6400, and the acid value was 80 mgKOH/g. The dispersant a was synthesized on the basis of a synthesizing method on the basis of a synthesizing method disclosed in paragraphs [0114] to [0140] and [0266] to [0348] of JP2007-277514A.

### [Preparation of Tin-Doped Indium Oxide Dispersion Liquid b]

28.1 parts by mass of a tin-doped indium oxide powder (P4-ITO, manufactured by Mitsubishi Materials Corporation), 18.8 parts by mass of a dispersant b (a solid content of 20%, and a solvent: propylene glycol monomethyl ether acetate), and 18.8 parts by mass of a solvent (cyclohexanone) were mixed in advance, and then were dispersed for 5 hours by a paint shaker (manufactured by Asada Iron Works Co., Ltd.) using zirconia beads having a diameter of 0.3 mm, and thus a tin-doped indium oxide dispersion liquid b (an ITO dispersion liquid b) was prepared.

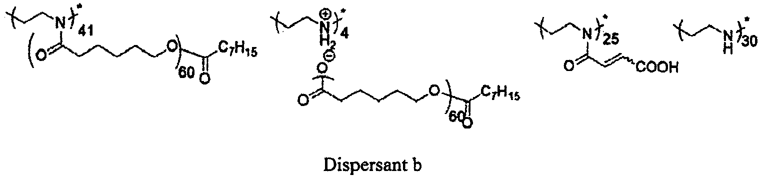

The weight average molecular weight (Mw) of the dispersant b was 9000, and the copolymerization ratio (the molar ratio) was as described above. The dispersant b was synthesized by a method disclosed in a publication of JP2012-255128A.

### [Preparation of Tin-Doped Indium Oxide Dispersion Liquid c]

28.1 parts by mass of a tin-doped indium oxide powder (P4-ITO, manufactured by Mitsubishi Materials Corporation), 13.5 parts by mass of a dispersant c (SOLSPERSE37500, manufactured by The Lubrizol Corporation, a solid content of 41.6%, and a solvent: propylene glycol monomethyl ether acetate), and 33.3 parts by mass of a solvent (cyclohexanone) were mixed in advance, and then were dispersed for 5 hours by a paint shaker (manufactured by Asada Iron Works Co., Ltd.) using zirconia beads having a diameter of 0.3 mm, and thus a tin-doped indium oxide dispersion liquid c (an ITO dispersion liquid c) was prepared.

### <Example 1>

The following compositions were mixed, and the mixed compositions were filtered by Membrane Filters (a pore diameter: 6 µm, manufactured by Nihon Pall Ltd.) and Membrane Filters (a pore diameter: 2.5 µm, manufactured by Nihon Pall Ltd.), and thus a composition for forming a far-infrared radiation shielding layer 1 was prepared.

### ITO Dispersion Liquid a 71.0 parts by mass

Binder Polymer (ACA230AA, manufactured by Daicel-Allnex Ltd., a solid content of 55%, and a solvent: propylene glycol monomethyl ether) 16.8 parts by mass

Photopolymerization Initiator: Irgacure907 (manufactured by BASF Japan Ltd.) 2.8 parts by mass

Polymerizing Compound: Aronix M-510 (TO-756) (a trade name, manufactured by Toagosei Co., Ltd.: a tetrafunctional polymerizing compound) 9.4 parts by mass

Silane Coupling Material KBM-602 (manufactured by Shin-Etsu Chemical Co., Ltd.) 0.11 parts by mass

Surfactant: Megaface F-780 (manufactured by DIC Corporation) 0.11 parts by mass

### <Example 2>

A composition for forming a far-infrared radiation shielding layer 2 was prepared according to the same sequence as that in Example 1 except that the ITO dispersion liquid b was used instead of the ITO dispersion liquid a.

### <Example 3>

A composition for forming a far-infrared radiation shielding layer 3 was prepared according to the same sequence as that in Example 1 except that the ITO dispersion liquid c was used instead of the ITO dispersion liquid a.

### <Example 4>

A composition for forming a far-infrared radiation shielding layer 4 was prepared according to the same sequence as that in Example 1 except that 0.53 parts by mass of UV-503 (manufactured by Daito Chemical Co., Ltd) was further added as the ultraviolet absorber.

### <Comparative Example 1>

A comparative composition 1 was prepared by using the same components as those in Example 1 except that an ITO powder (P4-ITO, manufactured by Mitsubishi Materials Corporation) was used instead of the ITO dispersion liquid a.

Furthermore, a dispersant was not contained in the comparative composition 1.

### <Comparative Example 2>

### [Preparation of Red Pigment Dispersion Liquid R1]

117 parts of C.I. Pigment Red 254 (PR254) as a coloring agent, 70 parts of a dispersant (Ajisper PB821, manufactured by Ajinomoto Fine-Techno Co., Inc.), and PGMEA (propylene glycol-1-monomethyl ether-2-acetate) which was used such that the solid content concentration was 18.7% were mixed and dispersed for 12 hours by a bead mill, and thus a red pigment dispersion liquid R1 was prepared.

### [Preparation of Red Pigment Dispersion Liquid R2]

151 parts of C.I. Pigment Red 177 (PR 177) as a coloring agent, 46 parts of a dispersant (Ajisper PB821, manufactured by Ajinomoto Fine-Techno Co., Inc.), and PGMEA which was used such that the solid content concentration was 19.7% were mixed and dispersed for 12 hours by a bead mill, and thus a red pigment dispersion liquid R2 was prepared.

### (Preparation of Comparative Composition 2)

The following components were stirred and mixed, and thus a comparative composition 2 was prepared.

Red Pigment Dispersion Liquid R1 18.63 parts by mass

Red Pigment Dispersion Liquid R2 7.15 parts by mass

Polymerizing Compound: Aronix TO-2359(manufactured by Toagosei Co., Ltd.) 2.46 parts by mass

Polymerization Initiator: a compound C 0.28 parts by mass

Sensitizer: Kayacure DETX-S (a thioxanthone-based compound, manufactured by Nippon Kayaku Co., Ltd.) 0.47 parts by mass

Binder Polymer: a PGMEA solution having a solid content of 40% of a random copolymer (molecular weight 30,000) of BzMA/MAA = 70/30 [molar ratio] 3.45 parts by mass

Solvent: EEP (3-ethoxy ethyl propionate) 7.41 parts by mass

Multifunctional Mercaptan-based Compound: Karenz MTBD1 (manufactured by Showa Denko K.K.) 0.378 parts

Polymerization Inhibitor: p-methoxy phenol 0.0012 parts by mass

Surfactant: Megaface F-554 (manufactured by DIC Corporation) 0.03 parts by mass

Compound C: The following compounds were synthesized according to JP2007-231000A.

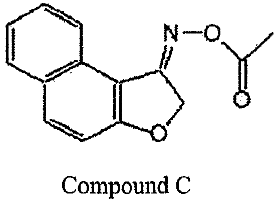

### < Formation of Far-Infrared Radiation Shielding Layer>

The obtained composition for forming a far-infrared radiation shielding layer described above was applied onto a silicon wafer of 4 inches by using a spin coating method, and then was heated on a hot plate at 100°C for 2 minutes, and thus a coated film having a film thickness of 5 µm was obtained. This coated film was exposed at 100 mJ/cm² through a mask having a linear pattern of 5 µm by using an extra high pressure mercury lamp "USH-500BY" manufactured by Ushio Inc.

The coated film was subjected to puddle development at room temperature for 60 seconds by using an alkaline developer (FHD-5) (manufactured by Fujifilm Electronic Materials Co., Ltd.), and was rinsed with pure water for 20 seconds by a spin shower. After that, the base was dried at a high-speed rotation, and thus a pattern was formed.

### <Measurement of Far-Infrared Ray Transmittance>

The far-infrared ray transmittance was measured by preparing four far-infrared radiation shielding layers having different film thicknesses on a Si substrate (a silicon substrate) by the method described above, and by using NICOLET6700FT-IR (manufactured by Terumo Corporation).

As the measurement conditions, the background was measured in a condition where the transmittance and the air were not corrected.

As the measurement result, inclinations and intercepts were obtained from plots of the film thickness and the absorbancy by a least square method.

The inclinations and the intercepts were applied to Lambert-Beer Equation: A = αCL + B (A: Absorbancy, α: Light Absorption Coefficient, C: Concentration, L: Film Thickness, and B: absorbancy of Si Substrate), and thus the transmittance at a wavelength of 10 µm in a film thickness of 5 µm was obtained. The results are collectively shown in table 1.

**Table 1**

| | Transmittance at Wavelength of 10 µm |
|---|---|
| Example 1 | 7.50% |
| Example 2 | 7.50% |
| Example 3 | 7.50% |
| Example 4 | 7.50% |
| Comparative Example 1 | Surface State was Impaired, and thus Evaluation was not Able to be Performed |
| Comparative Example 2 | Greater than or Equal to 10% |

As shown in Table 1 described above, it was confirmed that the far-infrared radiation shielding layer obtained by the composition of the present invention had excellent light shielding properties with respect to a far-infrared ray.

In contrast, in Comparative Example 1 in which the dispersant was not used, it was not possible to form a layer which was measurable. In addition, in Comparative Example 2 in which the inorganic fine particles were not used, the light shielding properties of the far-infrared ray were deteriorated compared to the examples.

## Claims

1. A composition for forming a far-infrared radiation shielding layer containing at least inorganic fine particles and a dispersant.

2. The composition for forming a far-infrared radiation shielding layer according to claim 1,
wherein the inorganic fine particles are conductive inorganic fine particles.

3. The composition for forming a far-infrared radiation shielding layer according to claim 1 or 2,
wherein transmittance (%) of the inorganic fine particles at 365 nm to 405 nm is greater than or equal to 10%.

4. The composition for forming a far-infrared radiation shielding layer according to any one of claims 1 to 3,
wherein the inorganic fine particles are indium tin oxide.

5. The composition for forming a far-infrared radiation shielding layer according to any one of claims 1 to 4,
wherein the dispersant contains a resin which has a repeating unit having a group X having a functional group of which pKa is less than or equal to 14, and an oligomer chain or a polymer chain Y having 40 to 10,000 atoms on a side chain, and contains a basic nitrogen atom, or a polymer compound which has a weight average molecular weight of less than or equal to 10,000 and is denoted by General Formula (1) described below. 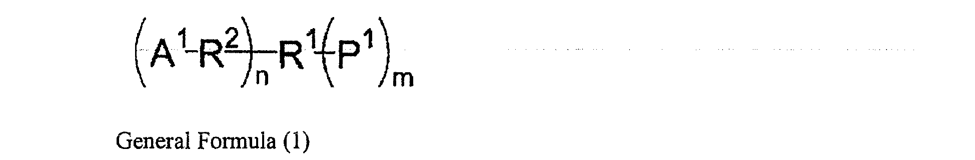
wherein in General Formula (1), R¹ represents a (m + n)-valent connecting group. R² represents a single bond or a bivalent connecting group, A¹ represents a monovalent substituent group having at least one group selected from a group consisting of an acid group, a urea group, a urethane group, a group having a coordinating oxygen atom, a group having a basic nitrogen atom, a heterocyclic group, an alkyloxycarbonyl group, an alkylaminocarbonyl group, a carboxylate group, a sulfonamide group, an alkoxysilyl group, an epoxy group, an isocyanate group, and a hydroxyl group, and n A¹s and R²s are respectively identical to each other or different from each other,
m represents a positive number of less than or equal to 8, n represents 1 to 9, and m + n satisfies 3 to 10, and
P¹ represents a polymer chain, and m P¹s are identical to each other or different from each other.

6. The composition for forming a far-infrared radiation shielding layer according to any one of claims 1 to 5, further containing a polymerization initiator, a polymerizing monomer, and a binder polymer.

7. The composition for forming a far-infrared radiation shielding layer according to any one of claims 4 to 6,
wherein a content of indium tin oxide is greater than or equal to 50 mass% in a total solid content.
